# EUROPEAN PATENT APPLICATION

(11) **EP 4 224 625 A1**
(43) Date of publication of application: **09.08.2023**
(21) Application number: 21875903.3
(22) Date of filing: 04.10.2021
(51) Int. Cl.: H01P 11/00, H01Q 1/22, H01Q 1/38, H05K 1/02

(54) **WIRING BOARD AND METHOD FOR MANUFACTURING WIRING BOARD**

(30) Priority: 02.10.2020 JP 2020167992; 01.10.2021 JP 2021163019
(71) Applicant: Dai Nippon Printing Co., Ltd., Tokyo 162-8001 (JP)
(72) Inventor: KINOSHITA, Kazuki, Tokyo 162-8001 (JP); IIMURA, Keita, Tokyo 162-8001 (JP); TAKE, Seiji, Tokyo 162-8001 (JP); KAWAGUCHI, Shuji, Tokyo 162-8001 (JP); SAKAKI, Masashi, Tokyo 162-8001 (JP)
(74) Representative: Müller-Boré & Partner Patentanwälte PartG mbB
(86) International application number: PCT/JP2021/036612
(87) International publication number: WO 2022/071608

(57) **Abstract**

A wiring board (10) includes a substrate (11), a wiring pattern area (20) arranged on the substrate (11) and including pieces of wiring (21), and a plurality of dummy pattern areas (30) arranged around the wiring pattern area (20) and electrically independent of the wiring (21). An aperture ratio (A21) of a first dummy pattern area (301), which is located next to the wiring pattern area (20), is not lower than an aperture ratio (A1) of the wiring pattern area (20). In addition, an aperture ratio (A22) of a second dummy pattern area (302), which is located next to the first dummy pattern area (301) and farther from the wiring pattern area (20) than the first dummy pattern area (301) is, is higher than the aperture ratio (A21) of the first dummy pattern area (301).

## Description

### Technical Field

An embodiment of the present disclosure relates to a wiring board and a method of manufacturing the wiring board.

### Background Art

These days, portable terminal devices such as smartphones and tablets are becoming more and more sophisticated in functionality, smaller in size, thinner in profile, and lighter in weight. These portable terminal devices use a plurality of communication bands, and therefore require a plurality of antennas corresponding to the communication bands. For example, a portable terminal device is equipped with a plurality of antennas such as a phone antenna, a wireless fidelity (Wi-Fi) antenna, a third generation (3G) antenna, a fourth generation (4G) antenna, a long term evolution (LTE) antenna, a Bluetooth (^{®}) antenna, and a near field communication (NFC) antenna. However, as portable terminal devices are becoming smaller, it imposes a limitation on an antenna mounting space and reduces antenna design flexibility. Moreover, since the antennas are provided in a limited space, radio sensitivity is not always satisfactory.

To address this issue, film antennas mountable in a display region of a portable terminal device have been developed. A film antenna has a structure in which, in a transparent antenna including a transparent base substrate on which an antenna pattern is formed, the antenna pattern is formed of a conductor mesh layer having a mesh structure including a conductor portion where an opaque conductor layer is formed and a plurality of openings where no such conductor is formed.

### Citation List

### Patent Literature

[Patent Literature 1]: Japanese Unexamined Patent Application Publication No. 2011-66610
[Patent Literature 2]: Specification of Japanese Patent No. 5636735
[Patent Literature 3]: Specification of Japanese Patent No. 5695947

By the way, for example, in a film antenna according to related art, a single mesh antenna, or a plurality of mesh antennas, is mounted on a transparent base substrate, and there exist both an area where an antenna pattern is formed on the transparent base substrate and an area where no antenna pattern is formed on the transparent base substrate. In this case, the presence of the area where no antenna pattern is formed makes it easier for the area where the antenna pattern is formed to be visually noticed. Therefore, a solution for making it harder for a wiring pattern such as an antenna pattern to be visually noticed is demanded.

One of objects of the present embodiment is to provide a wiring board that makes it harder for a wiring pattern area to be visually noticed, and a method of manufacturing the wiring board.

### Summary of Invention

A wiring board according to an embodiment of the present disclosure is a wiring board that includes: a substrate; a wiring pattern area arranged on the substrate and including pieces of wiring; and a plurality of dummy pattern areas arranged around the wiring pattern area and electrically independent of the wiring, wherein the substrate has transparency, among the plurality of dummy pattern areas, an aperture ratio of a first dummy pattern area, which is located next to the wiring pattern area, is not lower than an aperture ratio of the wiring pattern area, and among the plurality of dummy pattern areas, an aperture ratio of a second dummy pattern area, which is located next to the first dummy pattern area and farther from the wiring pattern area than the first dummy pattern area is, is higher than the aperture ratio of the first dummy pattern area.

In the wiring board according to an embodiment of the present disclosure, each as the wiring pattern area, a plurality of wiring pattern areas may exist, and at least one of the plurality of dummy pattern areas may be provided in such a way as to surround the plurality of wiring pattern areas.

In the wiring board according to an embodiment of the present disclosure, the aperture ratio of the wiring pattern area and aperture ratios of the plurality of dummy pattern areas may increase stepwise from the wiring pattern area toward the dummy pattern areas located farther from the wiring pattern area, a difference between the aperture ratio of the first dummy pattern area and the aperture ratio of the wiring pattern area may be within a range from 0% inclusive to 2% inclusive, and a difference between the aperture ratios of the dummy pattern areas located next to each other may be each within a range from 0.02% inclusive to 2% inclusive.

The wiring board according to an embodiment of the present disclosure may further include a peripheral area located around the dummy pattern area that is farthest from the wiring pattern area, wherein the peripheral area may have an aperture ratio of 100%.

In the wiring board according to an embodiment of the present disclosure, the aperture ratio of the wiring pattern area and aperture ratios of the plurality of dummy pattern areas may increase stepwise from the wiring pattern area toward the dummy pattern areas located farther from the wiring pattern area, a difference between the aperture ratio of the first dummy pattern area and the aperture ratio of the wiring pattern area may be within a range from 0% inclusive to 2% inclusive, and each of a difference between the aperture ratios of the dummy pattern areas located next to each other and a difference between the aperture ratio of the peripheral area and the dummy pattern area located next to the peripheral area may be within a range from 0.02% inclusive to 2% inclusive

In the wiring board according to an embodiment of the present disclosure, an outline of the wiring pattern area may include a first side and a second side that intersect with each other in a plan view, a vertex where the first side and the second side intersect with each other is defined as a first vertex, an extension line, of the first side, extending from the first vertex is defined as a first virtual line, an extension line, of the second side, extending from the first vertex is defined as a second virtual line, and given above definition, in an area located between the first virtual line and the second virtual line, an outline of the first dummy pattern area may have a shape of an arc having a center at the first vertex.

In the wiring board according to an embodiment of the present disclosure, in the area located between the first virtual line and the second virtual line, an outline of the second dummy pattern area may have a shape of an arc having a center at the first vertex.

A wiring board according to an embodiment of the present disclosure is a wiring board that includes: a substrate; a wiring pattern area arranged on the substrate and including pieces of wiring; and a plurality of dummy pattern areas arranged around the wiring pattern area and electrically independent of the wiring, wherein the substrate has transparency, an aperture ratio of a first dummy pattern area, which is located next to the wiring pattern area, among the plurality of dummy pattern areas is lower than an aperture ratio of a second dummy pattern area, which is located next to the first dummy pattern area and farther from the wiring pattern area than the first dummy pattern area is, among the plurality of dummy pattern areas, an outline of the first dummy pattern area includes a third side and a fourth side that intersect with each other in a plan view, a vertex where the third side and the fourth side intersect with each other is defined as a second vertex, an extension line, of the third side, extending from the second vertex is defined as a third virtual line, an extension line, of the fourth side, extending from the second vertex is defined as a fourth virtual line, and given above definition, in an area located between the third virtual line and the fourth virtual line, an outline of the second dummy pattern area has a shape of an arc having a center at the second vertex.

In the wiring board according to an embodiment of the present disclosure, each of the plurality of dummy pattern areas may include pieces of dummy wiring that are electrically independent of the wiring, each of the pieces of dummy wiring may include a first dummy wiring portion and a second dummy wiring portion, the first dummy wiring portions of the dummy pattern areas located next to each other may be arranged in parallel with each other, and the second dummy wiring portions of the dummy pattern areas located next to each other may be arranged in parallel with each other.

In the wiring board according to an embodiment of the present disclosure, the wiring pattern area may further include pieces of interconnection wiring interconnecting the pieces of wiring, each of the plurality of dummy pattern areas may include pieces of dummy wiring that are electrically independent of the wiring and the interconnection wiring, each of the pieces of dummy wiring may include a first dummy wiring portion and a second dummy wiring portion, the wiring and the first dummy wiring portion of each of the dummy pattern areas may be arranged in parallel with each other, and the interconnection wiring and the second dummy wiring portion of each of the dummy pattern areas may be arranged in parallel with each other.

A wiring board according to an embodiment of the present disclosure is a wiring board that includes: a substrate; a wiring pattern area arranged on the substrate and including pieces of wiring; and a dummy pattern area arranged around the wiring pattern area and electrically independent of the wiring, wherein the substrate has transparency, an outline of the wiring pattern area includes a first side and a second side that intersect with each other in a plan view, a vertex where the first side and the second side intersect with each other is defined as a first vertex, an extension line, of the first side, extending from the first vertex is defined as a first virtual line, an extension line, of the second side, extending from the first vertex is defined as a second virtual line, and given above definition, in an area located between the first virtual line and the second virtual line, an outline of the first dummy pattern area has a shape of an arc having a center at the first vertex.

The wiring board according to an embodiment of the present disclosure may have a radio-wave transmitting-and-receiving function.

An image display device according to an embodiment of the present disclosure is an image display device that includes: the wiring board according to an embodiment, and a display device underlying the wiring board, wherein the wiring pattern area is provided at a corner portion of the display device.

A method of manufacturing a wiring board according to an embodiment of the present disclosure is a method of manufacturing a wiring board that includes: preparing a substrate; and forming, on the substrate, a wiring pattern area including pieces of wiring, and a plurality of dummy pattern areas arranged around the wiring pattern area and electrically independent of the wiring, wherein the substrate has transparency, among the plurality of dummy pattern areas, an aperture ratio of a first dummy pattern area, which is located next to the wiring pattern area, is not lower than an aperture ratio of the wiring pattern area, and among the plurality of dummy pattern areas, an aperture ratio of a second dummy pattern area, which is located next to the first dummy pattern area and farther from the wiring pattern area than the first dummy pattern area is, is higher than the aperture ratio of the first dummy pattern area.

A method of manufacturing a wiring board according to an embodiment of the present disclosure is a method of manufacturing a wiring board that includes: preparing a substrate; and forming, on the substrate, a wiring pattern area including pieces of wiring, and a dummy pattern area arranged around the wiring pattern area and electrically independent of the wiring, wherein the substrate has transparency, an outline of the wiring pattern area includes a first side and a second side that intersect with each other in a plan view, a vertex where the first side and the second side intersect with each other is defined as a first vertex, an extension line, of the first side, extending from the first vertex is defined as a first virtual line, an extension line, of the second side, extending from the first vertex is defined as a second virtual line, and given above definition, in an area located between the first virtual line and the second virtual line, an outline of the first dummy pattern area has a shape of an arc having a center at the first vertex.

A method of manufacturing a wiring board according to an embodiment of the present disclosure is a method of manufacturing a wiring board that includes: preparing a substrate; and forming, on the substrate, a wiring pattern area including pieces of wiring, and a plurality of dummy pattern areas arranged around the wiring pattern area and electrically independent of the wiring, wherein the substrate has transparency, an aperture ratio of a first dummy pattern area, which is located next to the wiring pattern area, among the plurality of dummy pattern areas is lower than an aperture ratio of a second dummy pattern area, which is located next to the first dummy pattern area and farther from the wiring pattern area than the first dummy pattern area is, among the plurality of dummy pattern areas, an outline of the first dummy pattern area includes a third side and a fourth side that intersect with each other in a plan view, a vertex where the third side and the fourth side intersect with each other is defined as a second vertex, an extension line, of the third side, extending from the second vertex is defined as a third virtual line, an extension line, of the fourth side, extending from the second vertex is defined as a fourth virtual line, and given above definition, in an area located between the third virtual line and the fourth virtual line, an outline of the second dummy pattern area has a shape of an arc having a center at the second vertex.

With the embodiment of the present disclosure, it is possible to make it harder for a wiring pattern area to be visually noticed.

### Brief Description of Drawings

[Fig. 1] Fig. 1 is a plan view of a wiring board according to an embodiment.
[Fig. 2A] Fig. 2A is an enlarged plan view of a wiring board according to an embodiment (an enlarged view of a part IIA in Fig. 1).
[Fig. 2B] Fig. 2B is an enlarged plan view of a wiring board according to an embodiment (an enlarged view of a part IIB in Fig. 1).
[Fig. 3] Fig. 3 is a cross-sectional view of a wiring board according to an embodiment (a cross-sectional view taken along the line III-III in Fig. 2A).
[Fig. 4] Fig. 4 is a cross-sectional view of a wiring board according to an embodiment (a cross-sectional view taken along the line IV-IV in Fig. 2A).
[Fig. 5] Fig. 5 is a cross-sectional view of a wiring board according to an embodiment (a cross-sectional view taken along the line V-V in Fig. 2A).
[Fig. 6A] Fig. 6A is a cross-sectional view illustrating a method of manufacturing a wiring board according to an embodiment.
[Fig. 6B] Fig. 6B is a cross-sectional view illustrating the method of manufacturing a wiring board according to an embodiment.
[Fig. 6C] Fig. 6C is a cross-sectional view illustrating the method of manufacturing a wiring board according to an embodiment.
[Fig. 6D] Fig. 6D is a cross-sectional view illustrating the method of manufacturing a wiring board according to an embodiment.
[Fig. 6E] Fig. 6E is a cross-sectional view illustrating the method of manufacturing a wiring board according to an embodiment.
[Fig. 6F] Fig. 6F is a cross-sectional view illustrating the method of manufacturing a wiring board according to an embodiment.
[Fig. 7] Fig. 7 is a plan view of an image display device according to an embodiment.
[Fig. 8] Fig. 8 is a plan view of a wiring board according to a modification example of an embodiment.
[Fig. 9] Fig. 9 is a plan view of a wiring board according to a modification example of an embodiment.
[Fig. 10] Fig. 10 is an enlarged plan view of a wiring board according to a modification example of an embodiment (a diagram corresponding to Fig. 2A).
[Fig. 11] Fig. 11 is an enlarged plan view of a wiring board according to a modification example of an embodiment (a diagram corresponding to Fig. 2A).
[Fig. 12] Fig. 12 is an enlarged plan view of a wiring board according to a modification example of an embodiment (a diagram corresponding to Fig. 2A).
[Fig. 13] Fig. 13 is an enlarged plan view of a wiring board according to a modification example of an embodiment (a diagram corresponding to Fig. 2A).
[Fig. 14] Fig. 14 is an enlarged plan view of a wiring board according to a modification example of an embodiment.
[Fig. 15] Fig. 15 is an enlarged plan view of a wiring board according to a modification example of an embodiment.
[Fig. 16] Fig. 16 is a plan view of a wiring board according to a modification example of an embodiment.
[Fig. 17] Fig. 17 is an enlarged plan view of a wiring board according to an embodiment (an enlarged view of a part XVII in Fig. 16).
[Fig. 18] Fig. 18 is a plan view of an image display device according to a modification example of an embodiment.
[Fig. 19] Fig. 19 is a plan view of a wiring board according to a modification example of an embodiment.
[Fig. 20] Fig. 20 is a plan view of a wiring board according to a modification example of an embodiment.
[Fig. 21] Fig. 21 is a plan view of a wiring board according to a modification example of an embodiment.
[Fig. 22] Fig. 22 is a plan view of a wiring board according to a modification example of an embodiment.
[Fig. 23] Fig. 23 is a plan view of a wiring board according to a modification example of an embodiment.
[Fig. 24] Fig. 24 is a plan view of a wiring board according to a modification example of an embodiment.

### Description of Embodiments

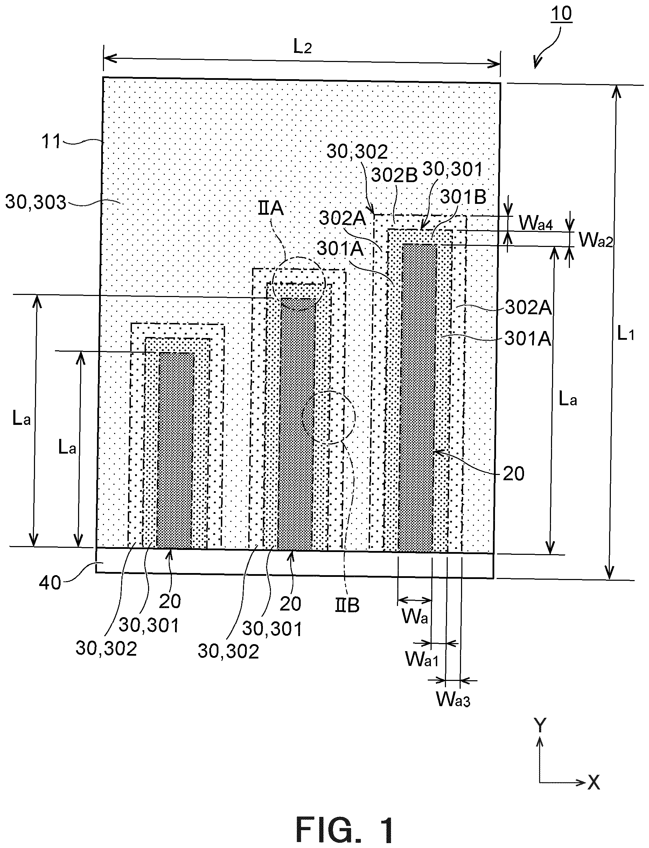

First, with reference to Figs. 1 to 7, an embodiment will now be described. Figs. 1 to 7 illustrate the embodiment.

The drawings mentioned below are schematic. Therefore, the illustration will be exaggerated where appropriate in order to facilitate understanding of sizes/shapes of portions. Modifications can be made as appropriate within a range of not departing from the technical idea. In the drawings mentioned below, the same reference signs will be assigned to the same portions, and detailed description may be partially omitted. Numerical values such as dimensions of members described in this specification, and material names thereof, are mere examples in the embodiment, and selection can be made as appropriate without any limitation to them. In this specification, terms that specify shapes and geometric conditions, for example, "parallel", "orthogonal", "perpendicular", and the like, shall be construed not only in a strict sense but also in a sense of being deemed to be substantially the same as their exact definitions.

In the present embodiment, the term "X direction" means a direction perpendicular to a longer-side direction of a wiring pattern area and perpendicular to a direction of a length corresponding to a frequency band of antenna wiring. The term "Y direction" means a direction perpendicular to the X direction and parallel to the longer-side direction of the wiring pattern area and parallel to the direction of the length corresponding to the frequency band of the antenna wiring. The term "Z direction" means a direction perpendicular to both the X direction and the Y direction and parallel to a thickness direction of a wiring board. The term "front surface" means a surface which is on a positive side in the Z direction and on which, with respect to the substrate, antenna wiring is provided. The term "back surface" means a surface which is on a negative side in the Z direction and is the opposite of the surface on which, with respect to the substrate, the antenna wiring is provided. In the present embodiment, a description will be given while taking, as an example, a case where a wiring pattern area 20 is an antenna pattern area 20 having a radio-wave transmitting-and-receiving function (a function to serve as an antenna). However, the wiring pattern area 20 does not necessarily have to have the radio-wave transmitting-and-receiving function (the function to serve as an antenna).

### [Configuration of Wiring Board]

With reference to Figs. 1 to 5, a configuration of a wiring board according to the present embodiment will now be described. Figs. 1 to 5 are diagrams illustrating a wiring board according to the present embodiment.

As illustrated in Fig. 1, the wiring board 10 according to the present embodiment is disposed in, for example, a display of an image display device. The wiring board 10 includes a substrate 11 that has transparency, an antenna pattern area(s) (a wiring pattern area(s)) 20 arranged on the substrate 11, and a plurality of dummy pattern areas 30 arranged around the antenna pattern area 20 on the substrate 11. A power feeding portion 40 is electrically connected to the antenna pattern area 20.

The substrate 11 has a substantially rectangular shape in a plan view. Its longer-side direction is parallel to the Y direction. Its shorter-side direction is parallel to the X direction. The substrate 11 has transparency and is substantially flat. Its thickness is substantially uniform as a whole. The length L₁ of the substrate 11 in its longer-side direction (Y direction) can be selected within a range from, for example, 100 mm inclusive to 200 mm inclusive. The length L₂ of the substrate 11 in its shorter-side direction (X direction) can be selected within a range from, for example, 50 mm inclusive to 100 mm inclusive.

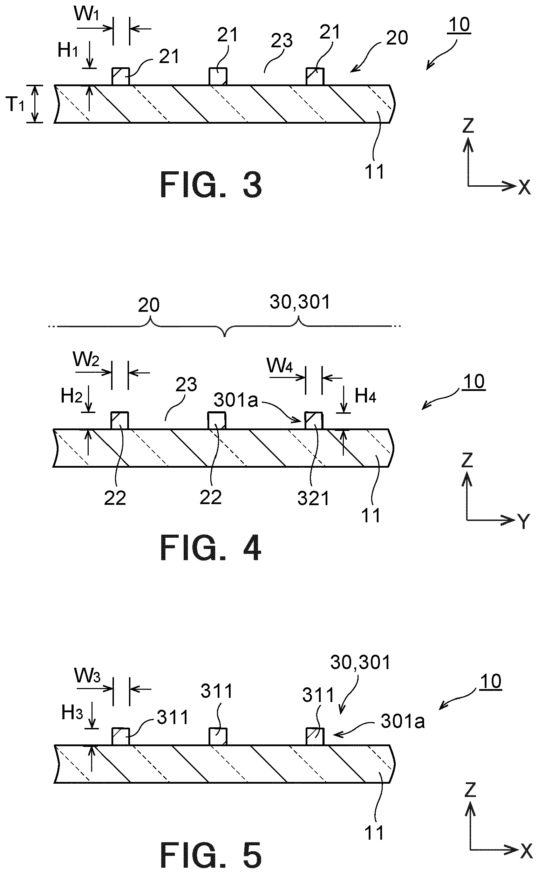

The material of the substrate 11 may be any material as long as it has transparency in the spectrum of visible light and has electric insulation property. In the present embodiment, the material of the substrate 11 is polyethylene terephthalate, but is not limited thereto. As the material of the substrate 11, it is preferable to use an organic insulating material, for example, a polyester-based resin such as polyethylene terephthalate, an acryl-based resin such as polymethyl methacrylate, a polycarbonate-based resin, a polyimide-based resin, a polyolefin-based resin such as a cycloolefin polymer, a cellulose-based resin material such as triacetyl cellulose, or the like. Alternatively, an organic insulating material such as a cycloolefin polymer (for example, ZF-16 manufactured by Zeon Corporation), a polynorbornene polymer (manufactured by Sumitomo Bakelite Co., Ltd.), or the like may be used as the material of the substrate 11. Glass, ceramics, or the like can be selected as the material of the substrate 11, depending on the intended use. In the illustrated example, the substrate 11 has a singlelayer structure, but is not limited thereto; it may have a structure made up of a plurality of bases or a multilayer structure. The substrate 11 may be like a film or like a plate. Therefore, the thickness of the substrate 11 is not specifically limited, and selection can be made as appropriate, depending on the intended use. As one example, the substrate 11 can have a thickness T₁ (a length in the Z direction, see Fig. 3) that is within a range from, for example, 10 µm inclusive to 200 µm inclusive.

The substrate 11 may have a dielectric loss tangent of 0.002 or less, or preferably, 0.001 or less. The lower limit of the dielectric loss tangent of the substrate 11, though not specifically limited, may be zero exclusive. Setting the dielectric loss tangent of the substrate 11 to the above range makes it possible to make a gain (sensitivity) loss in transmission and reception of an electromagnetic wave smaller, especially when the electromagnetic wave (for example, a millimeter wave) transmitted and received by the antenna pattern area 20 has a high frequency. The lower limit of the dielectric loss tangent of the substrate 11 is not specifically limited. The substrate 11 may have a relative permittivity of, though not specifically limited, 2.0 or more and 10.0 or less.

The dielectric loss tangent of the substrate 11 can be measured in conformity with IEC 62562. Specifically, first, a piece of test sample is prepared by cutting out of the substrate 11 a portion where the antenna pattern area 20 is not formed. Alternatively, a portion where the antenna pattern area 20 is formed may be cut out of the substrate 11, and the antenna pattern area 20 may be removed by etching or the like. The piece of test sample has a width of 10 mm to 20 mm and a length of 50 mm to 100 mm. Next, the dielectric loss tangent is measured in conformity with IEC 62562. The relative permittivity and dielectric loss tangent of the substrate 11 may be measured in conformity with ASTM D150.

The substrate 11 has transparency. In this specification, the meaning of "has transparency" is that the transmittance of visible light (light whose wavelengths are within a range from 400 nm inclusive to 700 nm inclusive) is 85% or greater. The substrate 11 may be transparent to an extent that the transmittance of visible light (light whose wavelengths are within a range from 400 nm inclusive to 700 nm inclusive) is 85% or greater, or preferably, 90% or greater. Though there is no specific upper limit in the transmittance of visible light through the substrate 11, for example, the limit may be 100% or less. Setting the transmittance of visible light through the substrate 11 to the above range makes it possible to enhance the transparency of the wiring board 10 and makes it easier to view a display 91 of an image display device 90 (to be described later). The visible light means light whose wavelengths are within a range from 400 nm inclusive to 700 nm inclusive. The meaning of "the transmittance of visible light is 85% or greater" is that the transmittance is 85% or greater throughout the entire spectrum within the range from 400 nm inclusive to 700 nm inclusive when light absorbance measurement is performed for the substrate 11 using a known spectrophotometer (for example, a spectroscope V-670 manufactured by JASCO corporation).

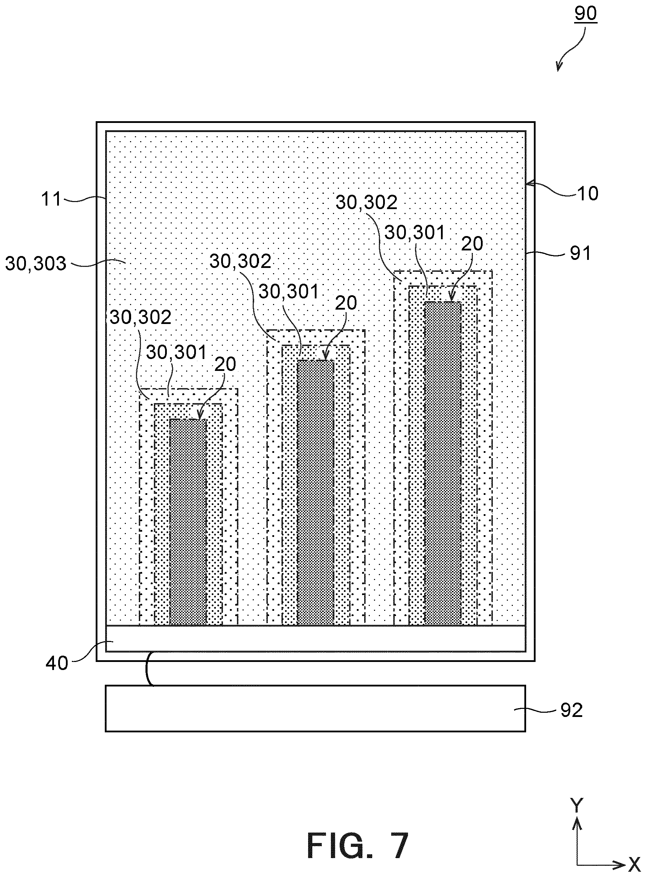

In Fig. 1, there exists a plurality of (three) antenna pattern areas 20 on the substrate 11. They correspond to frequency bands different from one another. That is, these antenna pattern areas 20 have lengths Lₐ (lengths in the Y direction) different from one another and corresponding to their respective specific frequency bands. The lower the corresponding frequency band is, the greater the length Lₐ of the antenna pattern area 20 is. For example, when the wiring board 10 is disposed in the display 91 of the image display device 90 (see Fig. 7, which will be described later), in a case where the wiring board 10 has a radio-wave transmitting-and-receiving function, each antenna pattern area 20 may correspond to any of a phone antenna, a Wi-Fi antenna, a 3G antenna, a 4G antenna, a 5G antenna, an LTE antenna, a Bluetooth (^{®}) antenna, an NFC antenna, and the like. Alternatively, in a case where the wiring board 10 does not have a radio-wave transmitting-and-receiving function, each antenna pattern area 20 may fulfill, for example, a hovering function (a function of enabling the user to operate a display without touching it directly), a fingerprint authentication function, a heater function, a noise-cut (shield) function, or the like. The antenna pattern area 20 may exist at a partial area only on the substrate 11, not the entire area on the substrate 11.

Each antenna pattern area 20 has a quadrangular shape in a plan view. In the present embodiment, each antenna pattern area 20 has a substantially rectangular shape in a plan view. The longer-side direction of each antenna pattern area 20 is parallel to the Y direction, and the shorter-side direction thereof is parallel to the X direction. The length Lₐ of each antenna pattern area 20 in its longer-side direction (Y direction) can be selected within a range from, for example, 3 mm inclusive to 100 mm inclusive. The width Wₐ of each antenna pattern area 20 in its shorter-side direction (X direction) can be selected within a range from, for example, 1 mm inclusive to 10 mm inclusive. The antenna pattern area 20 may function as a millimeter-wave antenna, among others. In a case where the antenna pattern area 20 is a millimeter-wave antenna, the length Lₐ of the antenna pattern area 20 can be selected within a range from 1 mm inclusive to 10 mm inclusive, or more preferably, 1.5 mm inclusive to 5 mm inclusive.

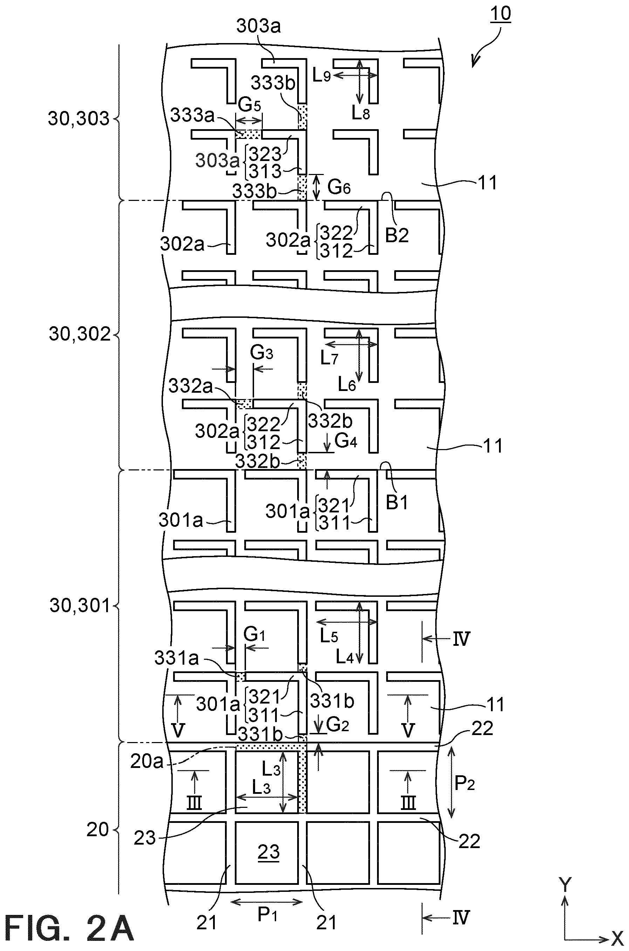

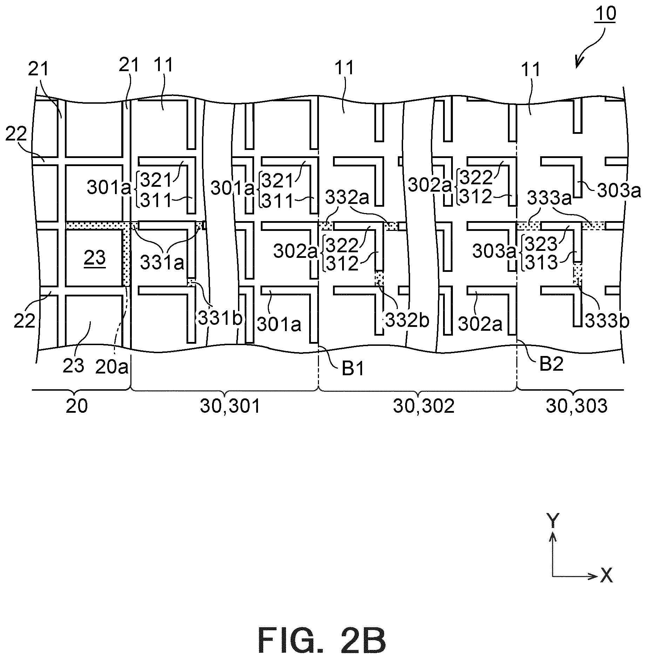

Each antenna pattern area 20 has a grid shape or a mesh shape formed of metal wiring and has a uniform iterative pattern in the X direction and the Y direction. That is, as illustrated in Figs. 2A and 2B, the antenna pattern area 20 is configured as an iterative array of unit pattern shapes 20a (a halftone-dotted portion in Figs. 2A and 2B) each of which has a shape like a letter L and is comprised of a shape portion extending in the X direction (a part of antenna interconnection wiring 22 to be described later) and a shape portion extending in the Y direction (a part of antenna wiring 21 to be described later).

As illustrated in Figs. 2A and 2B, each antenna pattern area 20 includes pieces of antenna wiring (wiring) 21 having a function to serve as an antenna and pieces of antenna interconnection wiring (interconnection wiring) 22 interconnecting the pieces of antenna wiring 21. Specifically, the pieces of antenna wiring 21 and the pieces of antenna interconnection wiring 22 form a regular array having a grid shape or a mesh shape as a whole. Each of the pieces of antenna wiring 21 extends in a direction corresponding to the frequency band of the antenna (Y direction). Each of the pieces of antenna interconnection wiring 22 extends in a direction orthogonal to the antenna wiring 21 (X direction). By having the length Lₐ corresponding to the predetermined frequency band (the above-mentioned length of the antenna pattern area 20), the antenna wiring 21 mainly fulfills a function to serve as the antenna. On the other hand, by interconnecting the pieces of antenna wiring 21, the antenna interconnection wiring 22 plays a role of preventing or reducing problems such as the breaking of the antenna wiring 21 or electric disconnection between the antenna wiring 21 and the power feeding portion 40.

In each antenna pattern area 20, a plurality of openings 23 is formed by being surrounded by the pieces of antenna wiring 21 arranged adjacent to one another and by the pieces of antenna interconnection wiring 22 arranged adjacent to one another. The pieces of antenna wiring 21 and the pieces of antenna interconnection wiring 22 are arranged at equal intervals with respect to one another. That is, the pieces of antenna wiring 21 are arranged at equal intervals with respect to one another, and the pitch P₁ (see Fig. 2A) of them can be selected within a range from, for example, 0.01 mm inclusive to 1 mm inclusive. The pieces of antenna interconnection wiring 22 are arranged at equal intervals with respect to one another, and the pitch P₂ (see Fig. 2A) of them can be selected within a range from, for example, 0.01 mm inclusive to 1 mm inclusive. Arranging each of the pieces of antenna wiring 21 and the pieces of antenna interconnection wiring 22 at equal intervals as described above eliminates or reduces a variation in size among the openings 23 inside each antenna pattern area 20, thereby making it harder for the antenna pattern area 20 to be noticed with the naked eye. In addition, the pitch P₁ of the pieces of antenna wiring 21 is equal to the pitch P₂ of the pieces of antenna interconnection wiring 22. Therefore, each opening 23 has a substantially square shape in a plan view, and the substrate 11 having transparency is exposed through each opening 23. For this reason, it is possible to enhance the transparency of the wiring board 10 as a whole by increasing the area size of each opening 23. The length L₃ (see Fig. 2A) of one side of each opening 23 can be selected within a range from, for example, 0.01 mm inclusive to 1 mm inclusive. Each of the pieces of antenna wiring 21 and each of the pieces of antenna interconnection wiring 22 are orthogonal to each other; however, the two may intersect with each other at an acute angle or at an obtuse angle, without any limitation thereto. Though it is preferable if the openings 23 have the same size and the same shape throughout the entire area, uniformity throughout the entire area is not necessarily required; for example, the size and/or shape of them may vary from position to position.

As illustrated in Fig. 3, each of the pieces of antenna wiring 21 has a substantially rectangular shape or a substantially square shape in cross section (X-directional cross section) perpendicular to its longer-side direction. In this case, the cross-sectional shape of the antenna wiring 21 is substantially uniform in the longer-side direction (Y direction) of the antenna wiring 21. As illustrated in Fig. 4, each of the pieces of antenna interconnection wiring 22 has a substantially rectangular shape or a substantially square shape in cross section (Y-directional cross section) perpendicular to its longer-side direction, and this cross-sectional shape is substantially the same as the cross-sectional shape (X-directional cross-sectional shape) of the antenna wiring 21 described above. In this case, the cross-sectional shape of the antenna interconnection wiring 22 is substantially uniform in the longer-side direction (X direction) of the antenna interconnection wiring 22. The cross-sectional shape of the antenna wiring 21 and the antenna interconnection wiring 22 does not necessarily have to be a substantially rectangular shape or a substantially square shape. For example, the shape may be substantially trapezoidal such that its front face (the positive side in the Z direction) is narrower than its back face (the negative side in the Z direction) or may have curved lateral faces at both sides in the width direction.

In the present embodiment, the line width W₁ (the length in the X direction, see Fig. 3) of the antenna wiring 21 and the line width W₂ (the length in the Y direction, see Fig. 4) of the antenna interconnection wiring 22 are not specifically limited, and can be selected as appropriate, depending on the intended use. For example, the line width W₁ of the antenna wiring 21 can be selected within a range from 0.1 µm inclusive to 5.0 µm inclusive, and the line width W₂ of the antenna interconnection wiring 22 can be selected within a range from 0.1 µm inclusive to 5.0 µm inclusive. In addition, the height H₁ (the length in the Z direction, see Fig. 3) of the antenna wiring 21 and the height H₂ (the length in the Z direction, see Fig. 4) of the antenna interconnection wiring 22 are not specifically limited, and can be selected as appropriate, depending on the intended use, for example, within a range from 0.1 µm inclusive to 5.0 µm inclusive.

The material of the antenna wiring 21 and the antenna interconnection wiring 22 may be any metal material having conductivity. In the present embodiment, the material of the antenna wiring 21 and the antenna interconnection wiring 22 is copper but is not limited thereto. For example, a metal material (including alloy) such as gold, silver, copper, platinum, tin, aluminum, iron, nickel, or the like can be used as the material of the antenna wiring 21 and the antenna interconnection wiring 22.

By the way, as described above, the wiring board 10 includes a plurality of dummy pattern areas 30. Referring back to Fig. 1, each dummy pattern area 30 is provided in such a way as to surround each antenna pattern area 20, and is formed in such a way as to surround all of the periphery sides (the positive side in the X direction, the negative side in the X direction, and the positive side in the Y direction) of each antenna pattern area 20, except for the side facing the power feeding portion 40 (the negative side in the Y direction). In this case, the dummy pattern area(s) 30 is arranged on the substrate 11 at substantially the entire area, except for the antenna pattern areas 20 and the power feeding portion 40. Unlike the antenna pattern area 20, the dummy pattern area 30 never fulfills a function to serve as the antenna.

In the illustrated example, the wiring board 10 includes three dummy pattern areas 30. That is, the wiring board 10 includes first dummy pattern areas 301 located next to the antenna pattern areas 20, second dummy pattern areas 302 located next to the first dummy pattern areas 301, and a third dummy pattern area 303 located next to the second dummy pattern areas 302. Among them, the second dummy pattern area 302 is located at a position farther from the antenna pattern area 20 than the first dummy pattern area 301 is, and surrounds the first dummy pattern area 301. The third dummy pattern area 303 is located at a position farther from the antenna pattern area 20 than the second dummy pattern area 302 is, and surrounds the second dummy pattern area 302. The number of the dummy pattern areas 30 included in the wiring board 10 may be any number, for example, two or more and fifty or less or so, or two or more and ten or less or so.

The first dummy pattern area 301 includes a pair of first portions 301A extending in the Y direction and a second portion 301B extending between the first portions 301A in the X direction. The width Wₐ₁ of the first portion 301A in its shorter-side direction (X direction) can be selected within a range from, for example, 0.1 mm inclusive to 50 mm inclusive, or preferably, within a range from 0.2 mm inclusive to 10 mm inclusive. The width Wₐ₂ of the second portion 301B in its shorter-side direction (Y direction) can be selected within a range from, for example, 0.1 mm inclusive to 50 mm inclusive, or preferably, within a range from 0.2 mm inclusive to 10 mm inclusive.

The second dummy pattern area 302 includes a pair of first portions 302A extending in the Y direction and a second portion 302B extending between the first portions 302A in the X direction. The width Wₐ₃ of the first portion 302A in its shorter-side direction (X direction) can be selected within a range from, for example, 0.1 mm inclusive to 50 mm inclusive, or preferably, within a range from 0.2 mm inclusive to 10 mm inclusive. The width Wₐ₄ of the second portion 302B in its shorter-side direction (Y direction) can be selected within a range from, for example, 0.1 mm inclusive to 50 mm inclusive, or preferably, within a range from 0.2 mm inclusive to 10 mm inclusive.

The width Wₐ₃ of the first portion 302A of the second dummy pattern area 302 may be greater than the width Wₐ₁ of the first portion 301A of the first dummy pattern area 301. As will be described later, in the present embodiment, the aperture ratio A22 of the second dummy pattern area 302 is higher than the aperture ratio A21 of the first dummy pattern area 301. Therefore, the width Wₐ₃ of the first portion 302A of the second dummy pattern area 302 is greater than the width Wₐ₁ of the first portion 301A of the first dummy pattern area 301, and this makes it possible to increase the aperture ratio of the wiring board 10 as a whole and enhance the transparency of the wiring board 10. Similarly, the width Wₐ₄ of the second portion 302B may be greater than the width Wₐ₂ of the second portion 301B of the first dummy pattern area 301. This makes it possible to increase the aperture ratio of the wiring board 10 as a whole and enhance the transparency of the wiring board 10.

The third dummy pattern area 303 is provided in such a way as to surround the plurality of antenna pattern areas 20. In the illustrated example, the third dummy pattern area 303 is provided in such a way as to surround all of the antenna pattern areas 20. This makes it harder for the plurality of antenna pattern areas 20 to be visually noticed effectively. The third dummy pattern area 303 is arranged on the substrate 11 at substantially the entire area, except for the antenna pattern areas 20, the first dummy pattern areas 301, the second dummy pattern areas 302, and the power feeding portion 40.

As illustrated in Figs. 2A and 2B, each of the plurality of dummy pattern areas 301, 302, 303 includes pieces of dummy wiring 301a, 302a, 303a that are electrically independent of the antenna wiring 21 (the antenna wiring 21 and the antenna interconnection wiring 22). Specifically, the first dummy pattern area 301 is configured as an iteration of dummy wiring 301a having a predetermined unit pattern shape, the second dummy pattern area 302 is configured as an iteration of dummy wiring 302a having a predetermined unit pattern shape, and the third dummy pattern area 303 is configured as an iteration of dummy wiring 303a having a predetermined unit pattern shape. That is, each of the dummy pattern areas 301, 302, and 303 includes pieces of dummy wiring 301a, 302a, 303a of identical shape, and each of the pieces of dummy wiring 301a, 302a, 303a is electrically independent of the antenna pattern area 20.

The pieces of dummy wiring 301a are arranged regularly throughout the entire first dummy pattern area 301. The pieces of dummy wiring 302a are arranged regularly throughout the entire second dummy pattern area 302. The pieces of dummy wiring 303a are arranged regularly throughout the entire third dummy pattern area 303. The pieces of dummy wiring 301a, 302a, 303a are separated from one another in a plane direction and are arranged like islands on the substrate 11 by protruding therefrom. That is, each of the pieces of dummy wiring 301a, 302a, 303a is electrically independent of the antenna pattern area 20, the power feeding portion 40, and the others of the pieces of dummy wiring.

Each of the pieces of dummy wiring 301a, 302a, 303a includes a first dummy wiring portion 311, 312, 313 and a second dummy wiring portion 321, 322, 323. In addition, as illustrated in Fig. 2A, the first dummy wiring portions 311, 312, and 313 of the dummy pattern areas 301, 302, and 303 located next to each other are arranged in parallel with each other. For example, the first dummy wiring portion 311 of the first dummy pattern area 301 and the first dummy wiring portion 312 of the second dummy pattern area 302 are arranged in parallel with each other. This makes it harder for the difference between the first dummy pattern area 301 and the second dummy pattern area 302 to be visually perceived in the Y direction. Moreover, the first dummy wiring portion 312 of the second dummy pattern area 302 and the first dummy wiring portion 313 of the third dummy pattern area 303 are arranged in parallel with each other. This makes it harder for the difference between the second dummy pattern area 302 and the third dummy pattern area 303 to be visually perceived in the Y direction.

Furthermore, as illustrated in Fig. 2A, the antenna wiring 21 of the antenna pattern area 20 and the first dummy wiring portions 311, 312, and 313 of the respective dummy pattern areas 301, 302, and 303 are arranged in parallel with each other. This makes it harder for the difference between the antenna pattern area 20 and each of the dummy pattern areas 301, 302, and 303 to be visually perceived in the Y direction.

Moreover, as illustrated in Fig. 2B, the second dummy wiring portions 321, 322, and 323 of the dummy pattern areas 301, 302, and 303 located next to each other are arranged in parallel with each other. For example, the second dummy wiring portion 321 of the first dummy pattern area 301 and the second dummy wiring portion 322 of the second dummy pattern area 302 are arranged in parallel with each other. This makes it harder for the difference between the first dummy pattern area 301 and the second dummy pattern area 302 to be visually perceived in the X direction. Moreover, the second dummy wiring portion 322 of the second dummy pattern area 302 and the second dummy wiring portion 323 of the third dummy pattern area 303 are arranged in parallel with each other. This makes it harder for the difference between the second dummy pattern area 302 and the third dummy pattern area 303 to be visually perceived in the X direction.

Furthermore, as illustrated in Fig. 2B, the antenna interconnection wiring 22 of the antenna pattern area 20 and the second dummy wiring portions 321, 322, and 323 of the respective dummy pattern areas 301, 302, and 303 are arranged in parallel with each other. This makes it harder for the difference between the antenna pattern area 20 and each of the dummy pattern areas 301, 302, and 303 to be visually perceived in the X direction.

Next, the dummy wiring 301a, 302a, and 303a will now be described in more detail. First, the dummy wiring 301a of the first dummy pattern area 301 will be described here.

### (Dummy Wiring of First Dummy Pattern Area)

As illustrated in Figs. 2A and 2B, each of the pieces of dummy wiring 301a has a shape like a letter L in a plan view and includes the first dummy wiring portion 311 extending in the Y direction and the second dummy wiring portion 321 extending in the X direction. The first dummy wiring portion 311 has a predetermined length L₄ (the length in the Y direction, see Fig. 2A), the second dummy wiring portion 321 has a predetermined length L₅ (the length in the X direction, see Fig. 2A), and these lengths are equal to each other (L₄ = L₅).

Moreover, in the first dummy pattern area 301, there is a clearance portion 331a (a halftone-dotted portion in Figs. 2A and 2B) between two pieces of dummy wiring 301a located next to each other in the X direction, and there is a clearance portion 331b (a halftone-dotted portion in Figs. 2A and 2B) between two pieces of dummy wiring 301a located next to each other in the Y direction. In this case, the pieces of dummy wiring 301a are arranged at equal intervals, with each adjacent two spaced from each other. That is, each two pieces of dummy wiring 301a located next to each other in the X direction are equally spaced from each other, and a gap G₁ therebetween can be selected within a range from, for example, 1 µm inclusive to 20 µm inclusive. Similarly, each two pieces of dummy wiring 301a located next to each other in the Y direction are equally spaced from each other, and a gap G₂ therebetween can be selected within a range from, for example, 1 µm inclusive to 20 µm inclusive. The maximum value of the gap G₁, G₂ may be 0.8 or less times as great as the aforementioned pitch P₁, P₂. In this case, the gap G₁ between the pieces of dummy wiring 301a in the X direction is equal to the gap G₂ between the pieces of dummy wiring 301a in the Y direction (G₁ = G₂).

In the present embodiment, the dummy wiring 301a has a shape of partial missing of the unit pattern shape 20a of the antenna pattern area 20 described earlier. That is, the shape of the dummy wiring 301a is a shape obtained by removing the clearance portion 331a, 331b described above from the unit pattern shape 20a, which is like a letter L, of the antenna pattern area 20. That is, a shape obtained by combining the pieces of dummy wiring 301a of the first dummy pattern area 301 and a plurality of clearance portions 331a, 331b thereof together is equivalent to the grid shape or the mesh shape of the antenna pattern area 20. Since the dummy wiring 301a of the first dummy pattern area 301 has a shape of partial missing of the unit pattern shape 20a of the antenna pattern area 20, it is possible to make it harder for the difference between the antenna pattern area 20 and the first dummy pattern area 301 to be visually perceived and thus make the antenna pattern area 20 formed on the substrate 11 more invisible.

In Fig. 2A, the antenna pattern area 20 and the first dummy pattern area 301 are located next to each other in the Y direction. The first dummy wiring portion 311 lies on an extension of the antenna wiring 21 near the boundary between the antenna pattern area 20 and the first dummy pattern area 301. This makes it harder for the difference between the antenna pattern area 20 and the first dummy pattern area 301 to be visually perceived in the Y direction.

Moreover, in Fig. 2B, the antenna pattern area 20 and the first dummy pattern area 301 are located next to each other in the X direction. The second dummy wiring portion 321 lies on an extension of the antenna interconnection wiring 22 near the boundary between the antenna pattern area 20 and the first dummy pattern area 301. This makes it harder for the difference between the antenna pattern area 20 and the first dummy pattern area 301 to be visually perceived in the X direction.

As illustrated in Fig. 5, the first dummy wiring portion 311 of each of the pieces of dummy wiring 301a has a substantially rectangular shape or a substantially square shape in cross section (X-directional cross section) perpendicular to its longer-side direction (Y direction). In addition, as illustrated in Fig. 4, the second dummy wiring portion 321 of each of the pieces of dummy wiring 301a has a substantially rectangular shape or a substantially square shape in cross section (Y-directional cross section) perpendicular to its longer-side direction (X direction). In this case, the cross-sectional shape of the first dummy wiring portion 311 is substantially the same as the cross-sectional shape of the antenna wiring 21, and the cross-sectional shape of the second dummy wiring portion 321 is substantially the same as the cross-sectional shape of the antenna interconnection wiring 22.

In the present embodiment, the line width W₃ (the length in the X direction, see Fig. 5) of the first dummy wiring portion 311 is substantially the same as the line width W₁ of the antenna wiring 21. The line width W₄ (the length in the Y direction, see Fig. 4) of the second dummy wiring portion 321 is substantially the same as the line width W₂ of the antenna interconnection wiring 22. The height H₃ (the length in the Z direction, see Fig. 5) of the first dummy wiring portion 311 and the height H₄ (the length in the Z direction, see Fig. 4) of the second dummy wiring portion 321 are also substantially the same as the height H₁ of the antenna wiring 21 and the height H₂ of the antenna interconnection wiring 22 respectively.

Next, the dummy wiring 302a of the second dummy pattern area 302 will now be described.

### (Dummy Wiring of Second Dummy Pattern Area)

As illustrated in Figs. 2A and 2B, each of the pieces of dummy wiring 302a has a shape like a letter L in a plan view and includes the first dummy wiring portion 312 extending in the Y direction and the second dummy wiring portion 322 extending in the X direction. The first dummy wiring portion 312 has a predetermined length L₆ (the length in the Y direction, see Fig. 2A), the second dummy wiring portion 322 has a predetermined length L₇ (the length in the X direction, see Fig. 2A), and these lengths are equal to each other (L₆ = L₇).

Moreover, in the second dummy pattern area 302, there is a clearance portion 332a (a halftone-dotted portion in Figs. 2A and 2B) between two pieces of dummy wiring 302a located next to each other in the X direction, and there is a clearance portion 332b (a halftone-dotted portion in Figs. 2A and 2B) between two pieces of dummy wiring 302a located next to each other in the Y direction. In this case, the pieces of dummy wiring 302a are arranged at equal intervals, with each adjacent two spaced from each other. That is, each two pieces of dummy wiring 302a located next to each other in the X direction are equally spaced from each other, and a gap G₃ therebetween can be selected within a range from, for example, 2 µm inclusive to 40 µm inclusive. Similarly, each two pieces of dummy wiring 302a located next to each other in the Y direction are equally spaced from each other, and a gap G₄ therebetween can be selected within a range from, for example, 2 µm inclusive to 40 µm inclusive. The maximum value of the gap G₃, G₄ may be 0.64 or less times as great as the aforementioned pitch P₁, P₂. In this case, the gap G₃ between the pieces of dummy wiring 302a in the X direction is equal to the gap G₄ between the pieces of dummy wiring 302a in the Y direction (G₃ = G₄).

In the present embodiment, the dummy wiring 302a has a shape of partial missing of the dummy wiring 301a described above. That is, the dummy wiring 302a has a shape of partial missing of the unit pattern shape 20a of the antenna pattern area 20. In this case, the shape of the dummy wiring 302a is a shape obtained by removing the clearance portion 332a, 332b described above from the unit pattern shape 20a, which is like a letter L, of the antenna pattern area 20. That is, a shape obtained by combining the pieces of dummy wiring 302a of the second dummy pattern area 302 and a plurality of clearance portions 332a, 332b thereof together is equivalent to the grid shape or the mesh shape of the antenna pattern area 20. Since the dummy wiring 302a of the second dummy pattern area 302 has a shape of partial missing of the dummy wiring 301a of the first dummy pattern area 301, it is possible to make it harder for the difference between the first dummy pattern area 301 and the second dummy pattern area 302 to be visually perceived and thus make the first dummy pattern area 301 and the second dummy pattern area 302 that are arranged on the substrate 11 more invisible.

In Fig. 2A, the first dummy pattern area 301 and the second dummy pattern area 302 are located next to each other in the Y direction. The first dummy wiring portion 312 of the second dummy pattern area 302 lies on an extension of the first dummy wiring portion 311 of the first dummy pattern area 301 near the boundary between the first dummy pattern area 301 and the second dummy pattern area 302. Therefore, it is hard to visually perceive the difference between the first dummy pattern area 301 and the second dummy pattern area 302 in the Y direction. In the illustrated example, the first dummy wiring portion 311 located next to a borderline B1, which is located between the first dummy pattern area 301 and the second dummy pattern area 302, and the first dummy wiring portion 312 located next to the borderline B1, are separated from each other; however, the layout is not limited to this example. For example, though not illustrated, the first dummy wiring portion 311 located next to the borderline B1 may be continuous to the first dummy wiring portion 312 located next to the borderline B1.

In addition, in Fig. 2B, the first dummy pattern area 301 and the second dummy pattern area 302 are located next to each other in the X direction. The second dummy wiring portion 322 of the second dummy pattern area 302 lies on an extension of the second dummy wiring portion 321 of the first dummy pattern area 301 near the boundary between the first dummy pattern area 301 and the second dummy pattern area 302. Therefore, it is hard to visually perceive the difference between the first dummy pattern area 301 and the second dummy pattern area 302 in the X direction. In the illustrated example, the second dummy wiring portion 321 located next to the borderline B1, which is located between the first dummy pattern area 301 and the second dummy pattern area 302, and the second dummy wiring portion 322 located next to the borderline B1, are separated from each other; however, the layout is not limited to this example. For example, though not illustrated, the second dummy wiring portion 321 located next to the borderline B1 may be continuous to the second dummy wiring portion 322 located next to the borderline B1.

In the present embodiment, the shape in terms of other parameters (cross-sectional shape in X-directional cross section, line width, and height) of the first dummy wiring portion 312 of the second dummy pattern area 302 is substantially the same as the shape of the first dummy wiring portion 311 of the first dummy pattern area 301; therefore, a detailed explanation is not given here. In addition, the shape in terms of other parameters (cross-sectional shape in Y-directional cross section, line width, and height) of the second dummy wiring portion 322 of the second dummy pattern area 302 is substantially the same as the shape of the second dummy wiring portion 321 of the first dummy pattern area 301; therefore, a detailed explanation is not given here.

Next, the dummy wiring 303a of the third dummy pattern area 303 will now be described.

### (Dummy Wiring of Third Dummy Pattern Area)

As illustrated in Figs. 2A and 2B, each of the pieces of dummy wiring 303a has a shape like a letter L in a plan view and includes the first dummy wiring portion 313 extending in the Y direction and the second dummy wiring portion 323 extending in the X direction. The first dummy wiring portion 313 has a predetermined length L₈ (the length in the Y direction, see Fig. 2A), the second dummy wiring portion 323 has a predetermined length L₉ (the length in the X direction, see Fig. 2A), and these lengths are equal to each other (L₈ = L₉).

Moreover, in the third dummy pattern area 303, there is a clearance portion 333a (a halftone-dotted portion in Figs. 2A and 2B) between two pieces of dummy wiring 303a located next to each other in the X direction, and there is a clearance portion 333b (a halftone-dotted portion in Figs. 2A and 2B) between two pieces of dummy wiring 303a located next to each other in the Y direction. In this case, the pieces of dummy wiring 303a are arranged at equal intervals, with each adjacent two spaced from each other. That is, each two pieces of dummy wiring 303a located next to each other in the X direction are equally spaced from each other, and a gap G₅ therebetween can be selected within a range from, for example, 6 µm inclusive to 60 µm inclusive. Similarly, each two pieces of dummy wiring 303a located next to each other in the Y direction are equally spaced from each other, and a gap G₆ therebetween can be selected within a range from, for example, 6 µm inclusive to 60 µm inclusive. The maximum value of the gap G₅, G₆ may be 0.51 or less times as great as the aforementioned pitch P₁, P₂. In this case, the gap G₅ between the pieces of dummy wiring 303a in the X direction is equal to the gap G₆ between the pieces of dummy wiring 303a in the Y direction (G₅ = G₆).

In the present embodiment, the dummy wiring 303a has a shape of partial missing of the dummy wiring 302a described above. That is, the dummy wiring 303a has a shape of partial missing of the unit pattern shape 20a of the antenna pattern area 20. In this case, the shape of the dummy wiring 303a is a shape obtained by removing the clearance portion 333a, 333b described above from the unit pattern shape 20a, which is like a letter L, of the antenna pattern area 20. That is, a shape obtained by combining the pieces of dummy wiring 303a of the third dummy pattern area 303 and a plurality of clearance portions 333a, 333b thereof together is equivalent to the grid shape or the mesh shape of the antenna pattern area 20. Since the dummy wiring 303a of the third dummy pattern area 303 has a shape of partial missing of the dummy wiring 302a of the second dummy pattern area 302, it is possible to make it harder for the difference between the second dummy pattern area 302 and the third dummy pattern area 303 to be visually perceived and thus make the second dummy pattern area 302 and the third dummy pattern area 303 that are arranged on the substrate 11 more invisible.

In Fig. 2A, the second dummy pattern area 302 and the third dummy pattern area 303 are located next to each other in the Y direction. The first dummy wiring portion 313 of the third dummy pattern area 303 lies on an extension of the first dummy wiring portion 312 of the second dummy pattern area 302 near the boundary between the second dummy pattern area 302 and the third dummy pattern area 303. Therefore, it is hard to visually perceive the difference between the second dummy pattern area 302 and the third dummy pattern area 303 in the Y direction. In the illustrated example, the first dummy wiring portion 312 located next to a borderline B2, which is located between the second dummy pattern area 302 and the third dummy pattern area 303, and the first dummy wiring portion 313 located next to the borderline B2, are separated from each other; however, the layout is not limited to this example. For example, though not illustrated, the first dummy wiring portion 312 located next to the borderline B2 may be continuous to the first dummy wiring portion 313 located next to the borderline B2.

In addition, in Fig. 2B, the second dummy pattern area 302 and the third dummy pattern area 303 are located next to each other in the X direction. The second dummy wiring portion 323 of the third dummy pattern area 303 lies on an extension of the second dummy wiring portion 322 of the second dummy pattern area 302 near the boundary between the second dummy pattern area 302 and the third dummy pattern area 303. Therefore, it is hard to visually perceive the difference between the second dummy pattern area 302 and the third dummy pattern area 303 in the X direction. In the illustrated example, the second dummy wiring portion 322 located next to the borderline B2, which is located between the second dummy pattern area 302 and the third dummy pattern area 303, and the second dummy wiring portion 323 located next to the borderline B2, are separated from each other; however, the layout is not limited to this example. For example, though not illustrated, the second dummy wiring portion 322 located next to the borderline B2 may be continuous to the second dummy wiring portion 323 located next to the borderline B1.

In the present embodiment, the shape in terms of other parameters (cross-sectional shape in X-directional cross section, line width, and height) of the first dummy wiring portion 313 of the third dummy pattern area 303 is substantially the same as the shape of the first dummy wiring portion 311 of the first dummy pattern area 301; therefore, a detailed explanation is not given here. In addition, the shape in terms of other parameters (cross-sectional shape in Y-directional cross section, line width, and height) of the second dummy wiring portion 323 of the third dummy pattern area 303 is substantially the same as the shape of the second dummy wiring portion 321 of the first dummy pattern area 301; therefore, a detailed explanation is not given here.

The same metal material as the material of the antenna wiring 21 and the material of the antenna interconnection wiring 22 can be used as the material of the dummy wiring 301a, 302a, and 303a described above.

By the way, in the present embodiment, the antenna pattern area 20, the first dummy pattern area 301, the second dummy pattern area 302, and the third dummy pattern area 303 have predetermined aperture ratios A1, A21, A22, and A23 respectively. In this case, the aperture ratio A21 of the first dummy pattern area 301 is not lower than the aperture ratio A1 of the antenna pattern area 20, and the aperture ratio A22 of the second dummy pattern area 302 is higher than the aperture ratio A21 of the first dummy pattern area 301. As described here, in the present embodiment, the aperture ratios A1, A21, A22, and A23 of the antenna pattern area 20 and the plurality of dummy pattern areas 30 increase stepwise from the antenna pattern area 20 toward the dummy pattern areas 30 located farther from the antenna pattern area 20. That is, the aperture ratio A21 of the first dummy pattern area 301 is not lower than the aperture ratio A1 of the antenna pattern area 20, the aperture ratio A22 of the second dummy pattern area 302 is higher than the aperture ratio A21 of the first dummy pattern area 301, and the aperture ratio A23 of the third dummy pattern area 303 is higher than the aperture ratio A22 of the second dummy pattern area 302 (A23 > A22 > A21 ≥ A1). This ensures sufficient transparency of the wiring board 10.

The difference between the aperture ratio A21 of the first dummy pattern area 301, which is located next to the antenna pattern area 20, and the aperture ratio A1 of the antenna pattern area 20 should preferably be within a range from 0% inclusive to 2% inclusive, more preferably, from 0.02% inclusive to 1% inclusive, still more preferably, from 0.08% inclusive to 0.5% inclusive. Setting the difference between the aperture ratio A21 and the aperture ratio A1 to 0% or greater makes it possible to enhance the transparency of the wiring board 10. Setting the difference between the aperture ratio A21 and the aperture ratio A1 to 2% or less makes it possible to make the difference between the aperture ratio A21 and the aperture ratio A1 small and thus make the boundary between the antenna pattern area 20 and the first dummy pattern area 301 more invisible. This makes it harder for the presence of the antenna pattern area 20 to be noticed with the naked eye. The difference from the aperture ratio A1 of the antenna pattern area 20 may be within a range from 0.1% inclusive to 3% inclusive.

Furthermore, the difference between the aperture ratios A21, A22, and A23 of the dummy pattern areas 30 located next to each other (for example, the difference between the aperture ratio A21 and the aperture ratio A22) should preferably be within a range from 0.02% inclusive to 2% inclusive, more preferably, from 0.04% inclusive to 1% inclusive, still more preferably, from 0.08% inclusive to 0.5% inclusive. Setting the difference between the aperture ratios A21, A22, and A23 to 0.02% or greater makes it possible to enhance the transparency of the wiring board 10. Setting the difference between the aperture ratios A21, A22, and A23 to 2% or less makes it possible to make the difference between, for example, the aperture ratio A21 and the aperture ratio A22 small and thus make the boundary between the first dummy pattern area 301 and the second dummy pattern area 302 more invisible. As described above, it is possible to make each boundary between the dummy pattern areas 30 more invisible and therefore make it harder for the presence of each dummy pattern area 30 to be noticed with the naked eye. The difference between the aperture ratios A21, A22, and A23 of the dummy pattern areas 30 located next to each other may be within a range from 0.1% inclusive to 3% inclusive.

The aperture ratio A1 of the antenna pattern area 20 described above can be selected within a range from, for example, 85% inclusive to 99.9% inclusive. The aperture ratio A21 of the first dummy pattern area 301 can be selected within a range from, for example, 85% inclusive to 100% exclusive. The aperture ratio A22 of the second dummy pattern area 302 can be selected within a range from, for example, 86% inclusive to 100% exclusive. The aperture ratio A23 of the third dummy pattern area 303 can be selected within a range from, for example, 86.5% inclusive to 100% exclusive.

An aperture ratio A3 of a combination area made up of the antenna pattern area 20 and the respective dummy pattern areas 30 (namely, the aperture ratio of the wiring board 10 as a whole) can be selected within a range from, for example, 87% inclusive to 100% exclusive. Selecting the aperture ratio A3 within this range ensures sufficient conductivity and transparency of the wiring board 10.

The term "aperture ratio" means an area-size ratio (%) of an open area (an area where no metal portion such as the antenna wiring 21, the antenna interconnection wiring 22, the dummy wiring 301a, 302a, and 303a exists and therefore the substrate 11 is exposed) to unit area of a predetermined area (the antenna pattern area 20, the dummy pattern area 30, or the antenna pattern area 20 and the dummy pattern area 30).

Referring back to Fig. 1, the power feeding portion 40 is electrically connected to the antenna pattern area 20. The power feeding portion 40 is a thin conductive member having a substantially rectangular shape. The longer-side direction of the power feeding portion 40 is parallel to the X direction. The shorter-side direction of the power feeding portion 40 is parallel to the Y direction. The power feeding portion 40 is disposed at the longer-side end (the negative-side end in the Y direction) of the substrate 11. For example, a metal material (including alloy) such as gold, silver, copper, platinum, tin, aluminum, iron, nickel, or the like can be used as the material of the power feeding portion 40. The power feeding portion 40 is electrically connected to a wireless communication circuit 92 of the image display device 90 when the wiring board 10 has been integrated in the image display device 90 (see Fig. 7). The power feeding portion 40 is provided in/on the front surface of the substrate 11, but is not limited thereto. A part or a whole of the power feeding portion 40 may be located outside the edge of the substrate 11.

### [Method of Manufacturing Wiring Board]

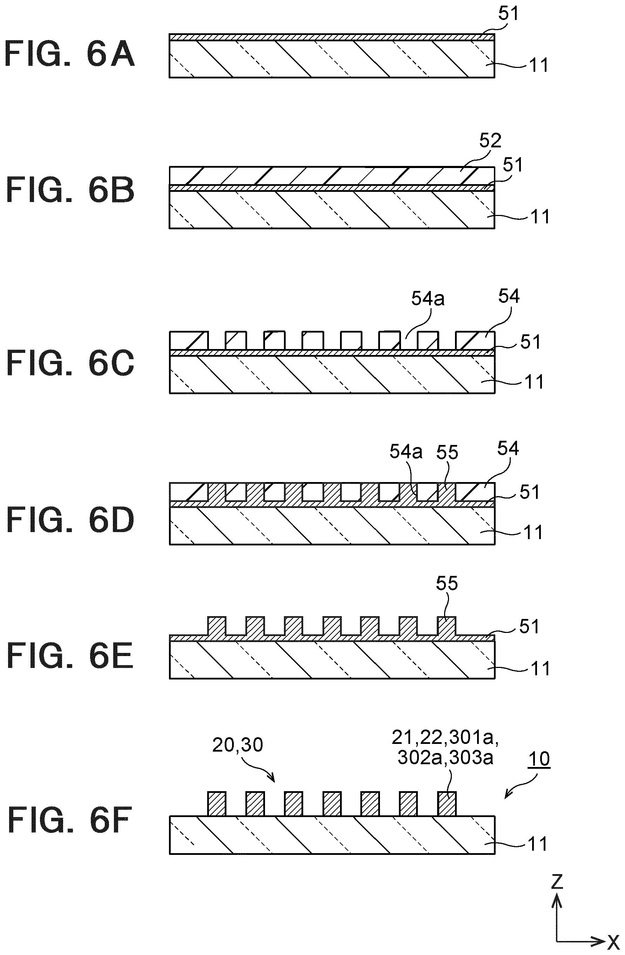

Next, with reference to Figs. 6A to 6F, a method of manufacturing a wiring board according to the present embodiment will now be described. Figs. 6A to 6F are cross-sectional views of a method of manufacturing a wiring board according to the present embodiment.

First, as illustrated in Fig. 6A, a substrate 11 that has transparency is prepared.

Next, an antenna pattern area 20 that includes pieces of antenna wiring 21 and a plurality of dummy pattern areas 30 arranged around the antenna pattern area 20 and electrically independent of the antenna wiring 21 are formed on the substrate 11. In this process, first, a conductive layer 51 is formed at substantially the entire area on the front surface of the substrate 11. In the present embodiment, the conductive layer 51 has a thickness of 200 nm. However, the thickness of the conductive layer 51, without being limited to the above, can be selected as appropriate within a range from 10 nm inclusive to 1,000 nm inclusive. In the present embodiment, the conductive layer 51 is formed by sputtering using copper. A plasma CVD method may be used for forming the conductive layer 51.

Next, as illustrated in Fig. 6B, a photo-curable insulating resist 52 is supplied to substantially the entire area over the front surface of the substrate 11. The photo-curable insulating resist 52 is, for example, organic resin such as acrylic resin or epoxy-based resin.

Then, as illustrated in Fig. 6C, an insulating layer 54 is formed by photolithography. In this case, by patterning the photo-curable insulating resist 52 using a photolithography method, the insulating layer 54 (resist pattern) that has trenches 54a is formed. The trenches 54a have a plane-shape pattern corresponding to the antenna wiring 21, the antenna interconnection wiring 22, and the dummy wiring 301a, 302a, and 303a. In this process, the insulating layer 54 is formed in such a way as to expose the conductive layer 51 corresponding to the antenna wiring 21, the antenna interconnection wiring 22, and the dummy wiring 301a, 302a, and 303a.

The trenches 54a can be formed using an imprint method, without being limited to the above, in the surface of the insulating layer 54. In this case, a transparent imprinting mold that has convex portions corresponding to the trenches 54a is prepared, the mold is brought close to the substrate 11, and the photo-curable insulating resist 52 is spread between the mold and the substrate 11. Next, light is applied from the mold side to cure the photo-curable insulating resist 52, thereby forming the insulating layer 54. As a result, the trenches 54a having a convex-pattern-transferred shape are formed. The insulating layer 54 having a cross-sectional structure illustrated in Fig. 6C can be obtained by thereafter separating the mold away from the insulating layer 54. Though not illustrated, it could happen that the residues of the insulating material remain on the bottom of the trenches 54a of the insulating layer 54. Therefore, the residues of the insulating material are removed by a wet process using a permanganate solution or N-methyl-2-pyrrolidone or a dry process using oxygen plasma. By removing the residues of the insulating material in this way, it is possible to form the trenches 54a exposing the conductive layer 51 as illustrated in Fig. 6C.

Next, as illustrated in Fig. 6D, the trenches 54a of the insulating layer 54 are filled with a conductor 55. In the present embodiment, the trenches 54a of the insulating layer 54 are filled with copper using an electroplating method, with the conductive layer 51 serving as a seed layer.

Next, as illustrated in Fig. 6E, the insulating layer 54 is removed. In this case, the insulating layer 54 over the substrate 11 is removed by a wet process using a permanganate solution, N-methyl-2-pyrrolidone, an acid solution, or an alkaline solution or a dry process using oxygen plasma.

After that, as illustrated in Fig. 6F, the conductive layer 51 on the front surface of the substrate 11 is removed. In this process, the conductive layer 51 is etched away in such a way as to expose the front surface of the substrate 11 by performing a wet process using a hydrogen peroxide water solution. In this way, the wiring board 10, which includes the substrate 11 and includes the antenna pattern area 20 and the dummy pattern area 30 that are arranged on the substrate 11, can be obtained. In this case, the aperture ratio A21 of the first dummy pattern area 301 is not lower than the aperture ratio A1 of the antenna pattern area 20, and the aperture ratio A22 of the second dummy pattern area 302 is higher than the aperture ratio A21 of the first dummy pattern area 301. In addition, the aperture ratio A23 of the third dummy pattern area 303 is higher than the aperture ratio A22 of the second dummy pattern area 302. In addition, the antenna pattern area 20 includes the antenna wiring 21 and the antenna interconnection wiring 22, and the dummy pattern area 30 includes the dummy wiring 301a, 302a, and 303a. The conductor 55 mentioned above includes the antenna wiring 21, the antenna interconnection wiring 22, and the dummy wiring 301a, 302a, and 303a.

### [Operational Effects of Present Embodiment]

Next, the operational effects of a wiring board having the configuration described above will now be explained.

As illustrated in Fig. 7, the wiring board 10 is integrated in the image display device 90 that includes the display (display device) 91. The image display device 90 includes the wiring board 10, and the display 91 underlying the wiring board 10. The wiring board 10 is disposed on the display 91. An example of such an image display device 90 is a portable terminal device such as a smartphone or a tablet. The antenna pattern area 20 of the wiring board 10 is electrically connected to the wireless communication circuit 92 of the image display device 90 via the power feeding portion 40. By this means, it is possible to transmit and receive a radio wave having a predetermined frequency via the antenna pattern area 20 and perform communication using the image display device 90. Since each dummy pattern area 30 is isolated from, and is electrically independent of, the antenna pattern area 20, there is no risk that the presence of each dummy pattern area 30 will affect the transmission and reception of a radio wave.

According to the present embodiment, the wiring board 10 includes the substrate 11 that has transparency and the antenna pattern area 20 arranged on the substrate 11 and including pieces of antenna wiring 21; therefore, sufficient transparency of the wiring board 10 is ensured. Therefore, the display 91 is viewable through the openings 23 of the antenna pattern area 20 when the wiring board 10 is disposed on the display 91; consequently, viewability of the display 91 is not impaired.

The plural dummy pattern areas 30 that are electrically independent of the antenna wiring 21 are arranged around the antenna pattern area 20. The aperture ratio A21 of the first dummy pattern area 301, which is located next to the antenna pattern area 20, is not lower than the aperture ratio A1 of the antenna pattern area 20. In addition, the aperture ratio A22 of the second dummy pattern area 302, which is located next to the first dummy pattern area 301 and farther from the wiring pattern area 20 than the first dummy pattern area 301 is, is higher than the aperture ratio A21 of the first dummy pattern area 301. This makes it possible to make each boundary between the antenna pattern area 20, the first dummy pattern area 301, and the second dummy pattern area 302 obscure. Therefore, it is possible to make the antenna pattern area 20, the first dummy pattern area 301, and the second dummy pattern area 302 more invisible on the surface of the display 91 and make it harder for the user of the image display device 90 to notice the antenna pattern area 20, the first dummy pattern area 301, and the second dummy pattern area 302 with the naked eye. Moreover, even when each boundary between the antenna pattern area 20, the first dummy pattern area 301, and the second dummy pattern area 302 is made obscure, it is possible to obtain a high aperture ratio A3 of the wiring board 10 as a whole because the aperture ratio A21 of the first dummy pattern area 301 is not lower than the aperture ratio A1 of the antenna pattern area 20 and because the aperture ratio A22 of the second dummy pattern area 302 is higher than the aperture ratio A21 of the first dummy pattern area 301. Therefore, it is possible to ensure sufficient conductivity and transparency of the wiring board 10.

In order to improve antenna performance, high conductivity of the antenna wiring 21 is required; however, for example, if the line width W₁ of the antenna wiring 21 is increased for the purpose of making the conductivity of the antenna wiring 21 higher, the aperture ratio A1 of the antenna pattern area 20 will decrease. In this case, it is conceivable to provide a dummy pattern area around the antenna pattern area 20 for the purpose of making the antenna pattern area 20 more invisible. In a case where a single dummy pattern area is provided around the antenna pattern area 20 (for example, if a single dummy pattern area is provided on the substrate 11 at substantially the entire area, except for the antenna pattern area 20), the decrease in the aperture ratio A1 of the antenna pattern area 20 necessitates that the aperture ratio of the dummy pattern area should also be decreased in order to make the boundary between the antenna pattern area 20 and the dummy pattern area obscure. Decreasing the aperture ratio of the dummy pattern area results in a decrease in the aperture ratio A3 of the wiring board 10 as a whole and, therefore, there is a possibility that the wiring board 10 will look dark as a whole. By contrast, according to the present embodiment, the wiring board 10 includes a plurality of dummy pattern areas 30, the aperture ratio A21 of the first dummy pattern area 301 is not lower than the aperture ratio A1 of the antenna pattern area 20, and the aperture ratio A22 of the second dummy pattern area 302 is higher than the aperture ratio A21 of the first dummy pattern area 301. Therefore, even in a case where the aperture ratio A1 of the antenna pattern area 20 is decreased, it is possible to obtain a high aperture ratio A3 of the wiring board 10 as a whole while making each boundary between the antenna pattern area 20, the first dummy pattern area 301, and the second dummy pattern area 302 obscure. Therefore, it is possible to ensure sufficient conductivity and transparency of the wiring board 10.

Moreover, according to the present embodiment, the third dummy pattern area 303 is provided in such a way as to surround a plurality of antenna pattern areas 20. This makes it harder for the plurality of antenna pattern areas 20 to be visually noticed effectively.

Moreover, according to the present embodiment, each of the plurality of dummy pattern areas 301, 302, 303 includes pieces of dummy wiring 301a, 302a, 303a that are electrically independent of the antenna wiring 21. Moreover, each of the pieces of dummy wiring 301a, 302a, 303a includes a first dummy wiring portion 311, 312, 313 and a second dummy wiring portion 321, 322, 323. In addition, the first dummy wiring portions 311, 312, and 313 of the dummy pattern areas 301, 302, and 303 located next to each other are arranged in parallel with each other. This makes it possible to make each boundary between the dummy pattern areas 301, 302, and 303 located next to each other obscure in the Y direction and make it harder for the dummy pattern areas 301, 302, and 303 to be noticed with the naked eye on the surface of the display 91.

Moreover, the second dummy wiring portions 321, 322, and 323 of the dummy pattern areas 301, 302, and 303 located next to each other are arranged in parallel with each other. This makes it possible to make each boundary between the dummy pattern areas 301, 302, and 303 located next to each other obscure in the X direction and make it harder for the dummy pattern areas 301, 302, and 303 to be noticed with the naked eye on the surface of the display 91.

Moreover, according to the present embodiment, the antenna pattern area 20 further includes pieces of antenna interconnection wiring 22 interconnecting the pieces of antenna wiring 21. Moreover, each of the plurality of dummy pattern areas 301, 302, 303 includes pieces of dummy wiring 301a, 302a, 303a that are electrically independent of the antenna wiring 21 and the antenna interconnection wiring 22. Moreover, each of the pieces of dummy wiring 301a, 302a, 303a includes a first dummy wiring portion 311, 312, 313 and a second dummy wiring portion 321, 322, 323. In addition, the antenna wiring 21 of the antenna pattern area 20 and the first dummy wiring portions 311, 312, and 313 of the respective dummy pattern areas 301, 302, and 303 are arranged in parallel with each other. This makes it possible to make the boundary of the antenna pattern area 20 and each dummy pattern area 301, 302, 303 obscure in the Y direction and make it harder for the antenna pattern area 20 and the dummy pattern areas 301, 302, and 303 to be noticed with the naked eye on the surface of the display 91.

Furthermore, as illustrated in Fig. 2B, the antenna interconnection wiring 22 of the antenna pattern area 20 and the second dummy wiring portions 321, 322, and 323 of the respective dummy pattern areas 301, 302, and 303 are arranged in parallel with each other. This makes it possible to make the boundary of the antenna pattern area 20 and each dummy pattern area 301, 302, 303 obscure in the X direction and make it harder for the antenna pattern area 20 and the dummy pattern areas 301, 302, and 303 to be noticed with the naked eye on the surface of the display 91.

### (Modification Examples)

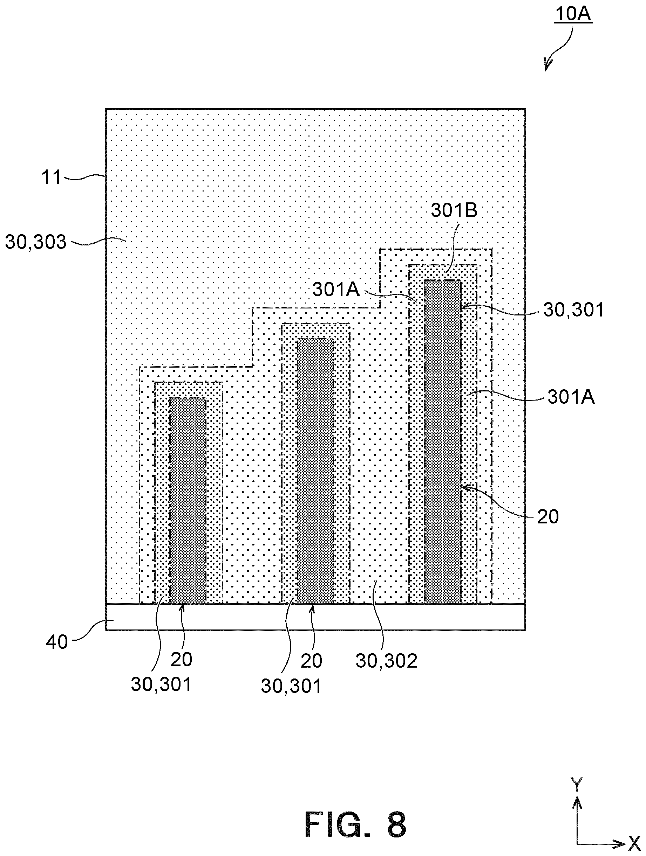

Next, with reference to Figs. 8 to 24, various modification examples of the wiring board will now be described. Figs. 8 to 24 are diagrams illustrating various modification examples of the wiring board. In the modification examples illustrated in Figs. 8 to 24, the configuration of the antenna pattern area 20 and/or the configuration of the dummy pattern area 30 are/is different, and except for this difference, the configuration of the illustrated modification examples is substantially the same as that of the foregoing embodiment. In Figs. 8 to 24, the same reference signs are assigned to portions that are the same as those of the embodiment illustrated in Figs. 1 to 7, and a detailed explanation of them will not be given below.

### (First Modification Example)

Fig. 8 illustrates a wiring board 10A according to a first modification example. In Fig. 8, the second dummy pattern area 302 is provided in such a way as to surround the plurality of antenna pattern areas 20. In the illustrated example, the second dummy pattern area 302 is provided in such a way as to surround all of the antenna pattern areas 20. Also in this case, it is possible to make it harder for the plurality of antenna pattern areas 20 to be visually noticed effectively.

Though not illustrated, the first dummy pattern area 301 may be provided in such a way as to surround the plurality of antenna pattern areas 20. In this case, the first dummy pattern area 301 may be provided in such a way as to surround all of the antenna pattern areas 20.

### (Second Modification Example)

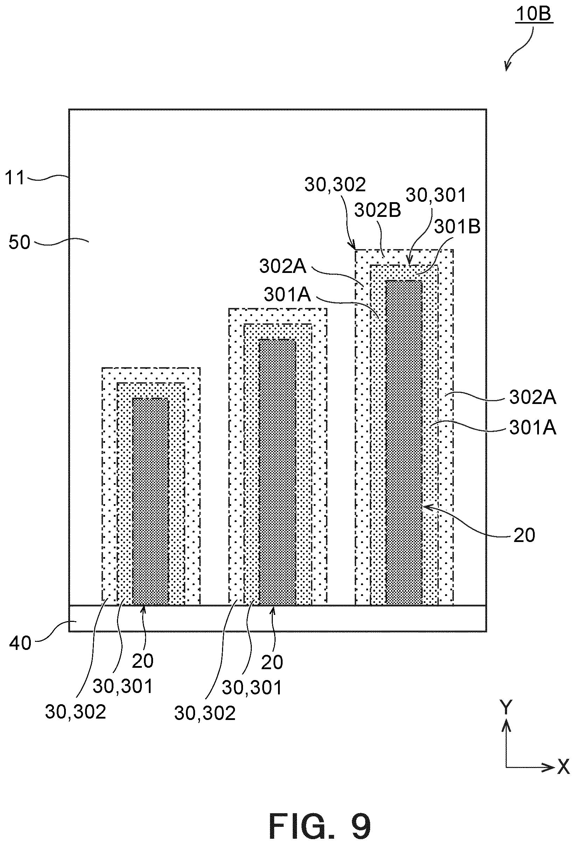

Fig. 9 illustrates a wiring board 10B according to a second modification example. In Fig. 9, the wiring board 10B further includes a peripheral area 50 located around the dummy pattern area 30 (in this modification example, the second dummy pattern area 302) that is farthest from the antenna pattern area 20. The peripheral area 50 has an aperture ratio of 100%. That is, the peripheral area 50 does not include any dummy wiring.

In this case, each of the difference between the aperture ratios of the dummy pattern areas 30 located next to each other and the difference between the aperture ratios of the peripheral area 50 and the dummy pattern area 30 located next to the peripheral area 50 may be within a range from 0.02% inclusive to 2% inclusive. Setting the above-mentioned difference to 0.02% or greater makes it possible to enhance the transparency of the wiring board 10. Setting the above-mentioned difference to 2% or less makes it possible to make the boundary between the dummy pattern area 30 and the peripheral area 50 more invisible. This makes it harder for the presence of the antenna pattern area 20 to be noticed with the naked eye.

As described above, the wiring board 10B further includes the peripheral area 50 located around the dummy pattern area 30 that is farthest from the antenna pattern area 20, and the peripheral area 50 has an aperture ratio of 100%; therefore, it is possible to obtain a high aperture ratio A3 of the wiring board 10B as a whole. For this reason, it is possible to enhance the transparency of the wiring board 10B.

### (Third Modification Example)

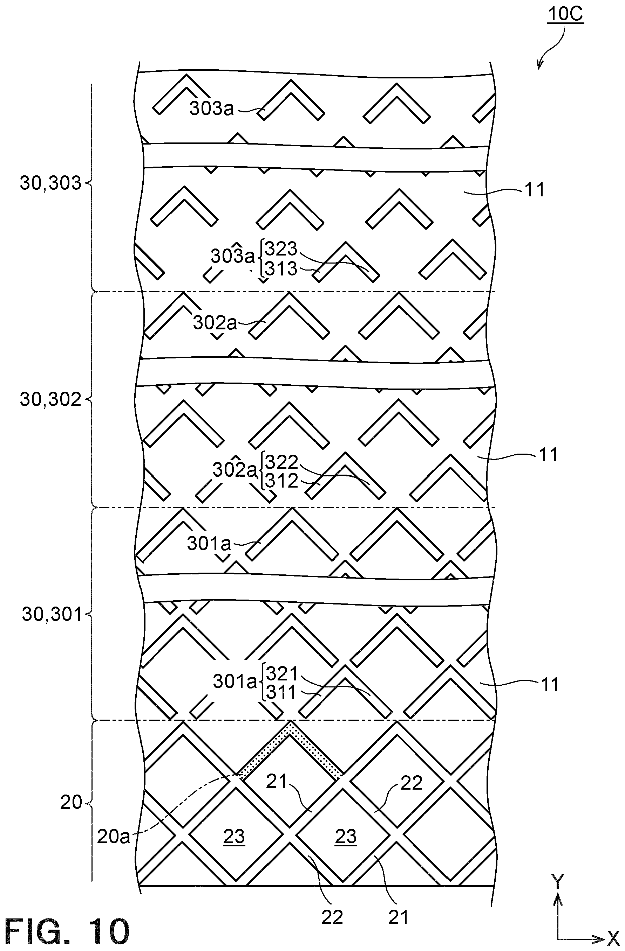

Fig. 10 illustrates a wiring board 10C according to a third modification example. In Fig. 10, the antenna wiring 21 and the antenna interconnection wiring 22 intersect diagonally, and each opening 23 has a shape like a rhombus in a plan view. Each of the antenna wiring 21 and the antenna interconnection wiring 22 is not parallel to the X direction nor to the Y direction.

Moreover, each of the first dummy wiring portion 311 of the first dummy pattern area 301, the first dummy wiring portion 312 of the second dummy pattern area 302, and the first dummy wiring portion 313 of the third dummy pattern area 303 extends in parallel with the antenna wiring 21. Similarly, each of the second dummy wiring portion 321 of the first dummy pattern area 301, the second dummy wiring portion 322 of the second dummy pattern area 302, and the second dummy wiring portion 323 of the third dummy pattern area 303 extends in parallel with the antenna interconnection wiring 22.

This modification example also makes it possible to make the boundary of the antenna pattern area 20 and each dummy pattern area 30 obscure. Therefore, it is possible to make the antenna pattern area 20 and each dummy pattern area 30 more invisible on the surface of the display 91 and make it harder for the user of the image display device 90 to notice the antenna pattern area 20 and each dummy pattern area 30 with the naked eye. Moreover, it is possible to ensure sufficient conductivity and transparency of the wiring board 10C.

### (Fourth Modification Example)

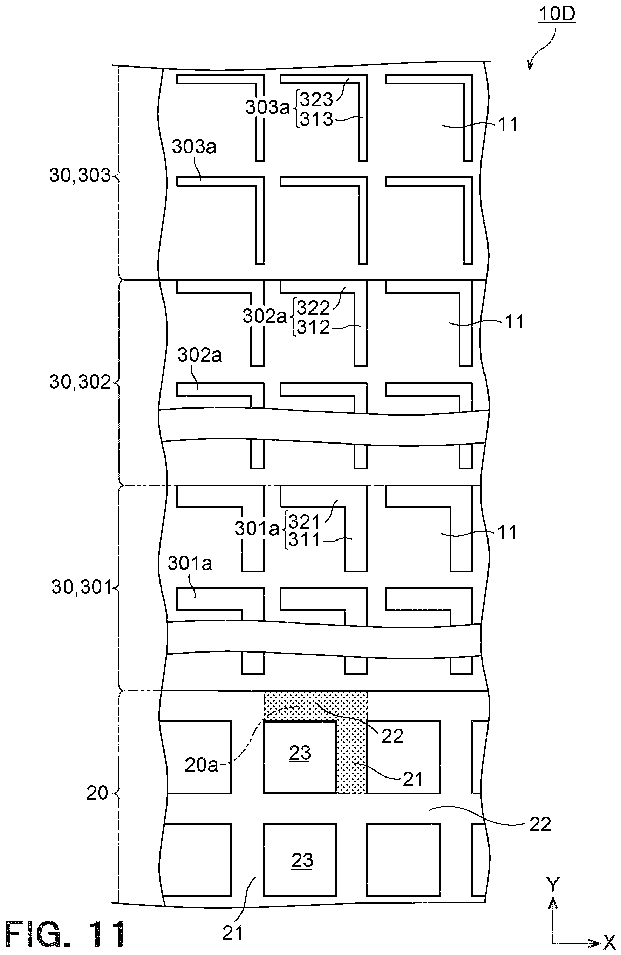

Fig. 11 illustrates a wiring board 10D according to a fourth modification example. In Fig. 11, the line widths of the antenna wiring 21 and the first dummy wiring portions 311, 312, and 313 decrease stepwise from the antenna pattern area 20 toward the dummy pattern areas 30 located farther from the antenna pattern area 20. That is, the line width of the first dummy wiring portion 311 of the first dummy pattern area 301 is less than the line width of the antenna wiring 21 of the antenna pattern area 20. Moreover, the line width of the first dummy wiring portion 312 of the second dummy pattern area 302 is less than the line width of the first dummy wiring portion 311 of the first dummy pattern area 301. Furthermore, the line width of the first dummy wiring portion 313 of the third dummy pattern area 303 is less than the line width of the first dummy wiring portion 312 of the second dummy pattern area 302.

Configuring the line widths of the antenna wiring 21 and the first dummy wiring portions 311, 312, and 313 in such a way as to decrease stepwise from the antenna pattern area 20 toward the dummy pattern areas 30 located farther from the antenna pattern area 20 as described above makes it possible to increase the aperture ratios A1, A21, A22, and A23 of the antenna pattern area 20 and the plurality of dummy pattern areas 30 stepwise from the antenna pattern area 20 toward the dummy pattern areas 30 located farther from the antenna pattern area 20.

Moreover, in Fig. 11, the line widths of the antenna interconnection wiring 22 and the second dummy wiring portions 321, 322, and 323 decrease stepwise from the antenna pattern area 20 toward the dummy pattern areas 30 located farther from the antenna pattern area 20. That is, the line width of the second dummy wiring portion 321 of the first dummy pattern area 301 is less than the line width of the antenna interconnection wiring 22 of the antenna pattern area 20. Moreover, the line width of the second dummy wiring portion 322 of the second dummy pattern area 302 is less than the line width of the second dummy wiring portion 321 of the first dummy pattern area 301. Furthermore, the line width of the second dummy wiring portion 323 of the third dummy pattern area 303 is less than the line width of the second dummy wiring portion 322 of the second dummy pattern area 302.

Configuring the line widths of the antenna interconnection wiring 22 and the second dummy wiring portions 321, 322, and 323 in such a way as to decrease stepwise from the antenna pattern area 20 toward the dummy pattern areas 30 located farther from the antenna pattern area 20 as described above makes it possible to increase the aperture ratios A1, A21, A22, and A23 of the antenna pattern area 20 and the plurality of dummy pattern areas 30 stepwise from the antenna pattern area 20 toward the dummy pattern areas 30 located farther from the antenna pattern area 20.

### (Fifth Modification Example)

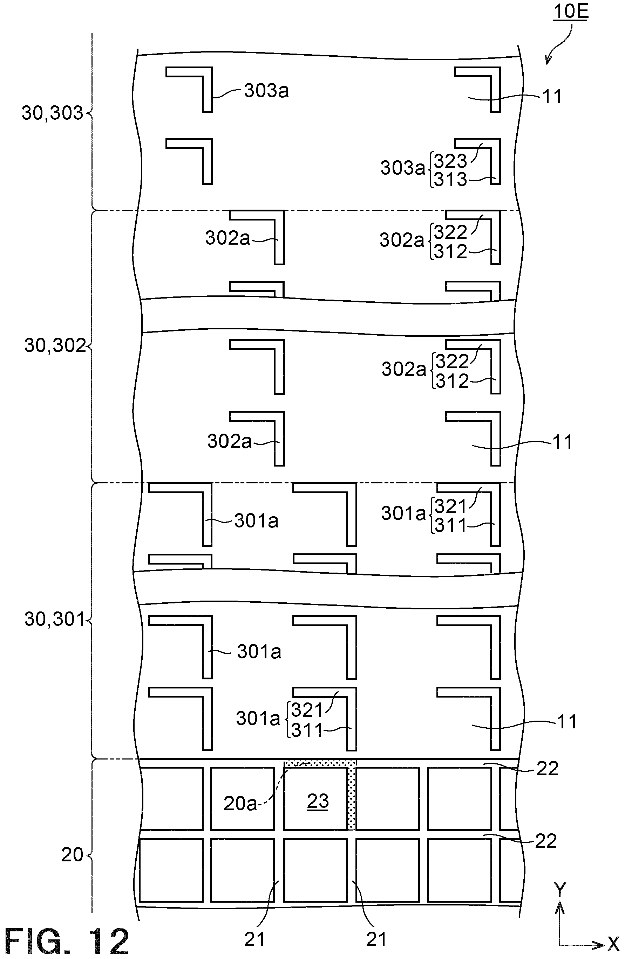

Fig. 12 illustrates a wiring board 10E according to a fifth modification example. In Fig. 12, the pitches of the antenna wiring 21 and the first dummy wiring portions 311, 312, and 313 increase stepwise from the antenna pattern area 20 toward the dummy pattern areas 30 located farther from the antenna pattern area 20. That is, the pitch of the first dummy wiring portion 311 of the first dummy pattern area 301 is greater than the pitch of the antenna wiring 21 of the antenna pattern area 20. Moreover, the pitch of the first dummy wiring portion 312 of the second dummy pattern area 302 is greater than the pitch of the first dummy wiring portion 311 of the first dummy pattern area 301. Furthermore, the pitch of the first dummy wiring portion 313 of the third dummy pattern area 303 is greater than the pitch of the first dummy wiring portion 312 of the second dummy pattern area 302.

In the illustrated example, each of the pitches of the first dummy wiring portions 311, 312, and 313 is an integral multiple of the pitch of the antenna wiring 21. Specifically, the pitch of the first dummy wiring portion 311 is twice as great as the pitch of the antenna wiring 21, the pitch of the first dummy wiring portion 312 is three times as great as the pitch of the antenna wiring 21, and the pitch of the first dummy wiring portion 313 is four times as great as the pitch of the antenna wiring 21. Each of the pitches of the first dummy wiring portions 311, 312, and 313 does not necessarily have to be an integral multiple of the pitch of the antenna wiring 21.

Configuring the pitches of the antenna wiring 21 and the first dummy wiring portions 311, 312, and 313 in such a way as to increase stepwise from the antenna pattern area 20 toward the dummy pattern areas 30 located farther from the antenna pattern area 20 as described above makes it possible to increase the aperture ratios A1, A21, A22, and A23 of the antenna pattern area 20 and the plurality of dummy pattern areas 30 stepwise from the antenna pattern area 20 toward the dummy pattern areas 30 located farther from the antenna pattern area 20.

Moreover, in Fig. 12, the pitches of the antenna interconnection wiring 22 and the second dummy wiring portions 321, 322, and 323 increase stepwise from the antenna pattern area 20 toward the dummy pattern areas 30 located farther from the antenna pattern area 20. That is, the pitch of the second dummy wiring portion 321 of the first dummy pattern area 301 is greater than the pitch of the antenna interconnection wiring 22 of the antenna pattern area 20. Moreover, the pitch of the second dummy wiring portion 322 of the second dummy pattern area 302 is greater than the pitch of the second dummy wiring portion 321 of the first dummy pattern area 301. Furthermore, the pitch of the second dummy wiring portion 323 of the third dummy pattern area 303 is greater than the pitch of the second dummy wiring portion 322 of the second dummy pattern area 302.

In the illustrated example, each of the pitches of the second dummy wiring portions 321, 322, and 323 is an integral multiple of the pitch of the antenna interconnection wiring 22. Specifically, the pitch of the second dummy wiring portion 321 is twice as great as the pitch of the antenna interconnection wiring 22, the pitch of the second dummy wiring portion 322 is three times as great as the pitch of the antenna interconnection wiring 22, and the pitch of the second dummy wiring portion 323 is four times as great as the pitch of the antenna interconnection wiring 22. Each of the pitches of the second dummy wiring portions 321, 322, and 323 does not necessarily have to be an integral multiple of the pitch of the antenna interconnection wiring 22.

Configuring the pitches of the antenna interconnection wiring 22 and the second dummy wiring portions 321, 322, and 323 in such a way as to increase stepwise from the antenna pattern area 20 toward the dummy pattern areas 30 located farther from the antenna pattern area 20 as described above makes it possible to increase the aperture ratios A1, A21, A22, and A23 of the antenna pattern area 20 and the plurality of dummy pattern areas 30 stepwise from the antenna pattern area 20 toward the dummy pattern areas 30 located farther from the antenna pattern area 20.

### (Sixth Modification Example)

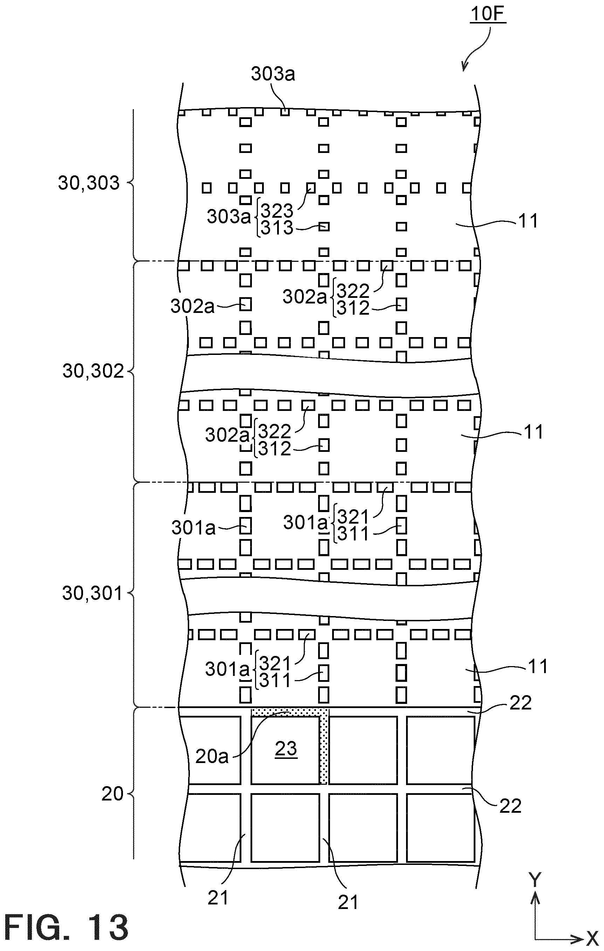

Fig. 13 illustrates a wiring board 10F according to a sixth modification example. In Fig. 13, the first dummy wiring portions 311, 312, and 313 are formed to have a broken-line pattern. Moreover, breaks in the first dummy wiring portions 311, 312, and 313 formed to have the broken-line pattern increase in length stepwise from the dummy pattern area 30 located next to the antenna pattern area 20 toward the dummy pattern areas 30 located farther from the antenna pattern area 20. That is, breaks in the first dummy wiring portion 312 of the second dummy pattern area 302 are longer than breaks in the first dummy wiring portion 311 of the first dummy pattern area 301. Moreover, breaks in the first dummy wiring portion 313 of the third dummy pattern area 303 are longer than breaks in the first dummy wiring portion 312 of the second dummy pattern area 302.

As described above, the first dummy wiring portions 311, 312, and 313 are formed to have a broken-line pattern, and breaks in the first dummy wiring portions 311, 312, and 313 formed to have the broken-line pattern increase in length stepwise from the dummy pattern area 30 located next to the antenna pattern area 20 toward the dummy pattern areas 30 located farther from the antenna pattern area 20; this makes it possible to increase the aperture ratios A1, A21, A22, and A23 of the antenna pattern area 20 and the plurality of dummy pattern areas 30 stepwise from the antenna pattern area 20 toward the dummy pattern areas 30 located farther from the antenna pattern area 20.

In Fig. 13, the second dummy wiring portions 321, 322, and 323 are formed to have a broken-line pattern. Moreover, breaks in the second dummy wiring portions 321, 322, and 323 formed to have the broken-line pattern increase in length stepwise from the dummy pattern area 30 located next to the antenna pattern area 20 toward the dummy pattern areas 30 located farther from the antenna pattern area 20. That is, breaks in the second dummy wiring portion 322 of the second dummy pattern area 302 are longer than breaks in the second dummy wiring portion 321 of the first dummy pattern area 301. Moreover, breaks in the second dummy wiring portion 323 of the third dummy pattern area 303 are longer than breaks in the second dummy wiring portion 322 of the second dummy pattern area 302.

As described above, the second dummy wiring portions 321, 322, and 323 are formed to have a broken-line pattern, and breaks in the second dummy wiring portions 321, 322, and 323 formed to have the broken-line pattern increase in length stepwise from the dummy pattern area 30 located next to the antenna pattern area 20 toward the dummy pattern areas 30 located farther from the antenna pattern area 20; this makes it possible to increase the aperture ratios A1, A21, A22, and A23 of the antenna pattern area 20 and the plurality of dummy pattern areas 30 stepwise from the antenna pattern area 20 toward the dummy pattern areas 30 located farther from the antenna pattern area 20.

### (Seventh Modification Example)

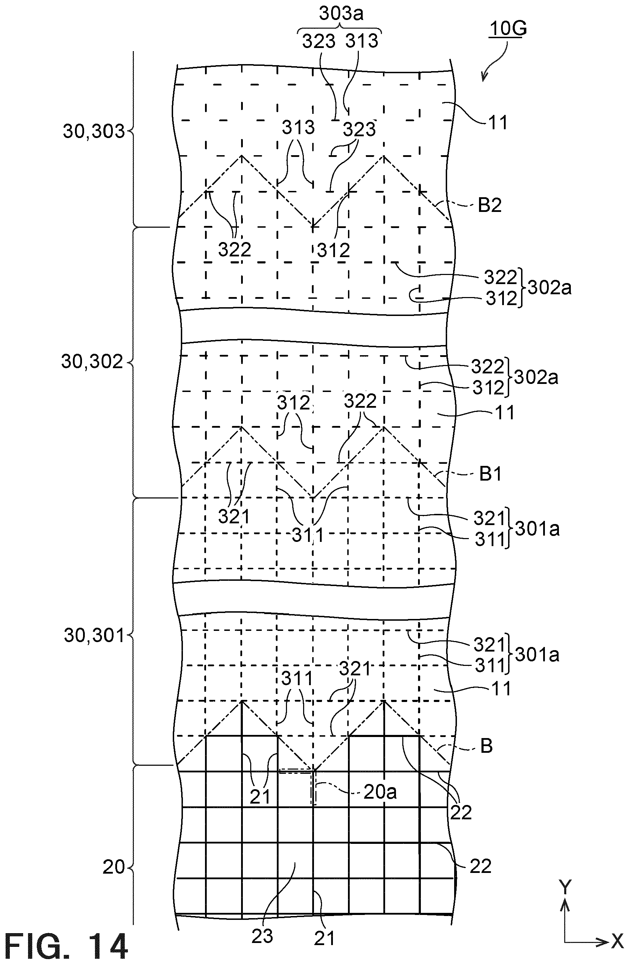

Fig. 14 illustrates a wiring board 10G according to a seventh modification example. In Fig. 14, each of a borderline B between the antenna pattern area 20 and the first dummy pattern area 301, a borderline B1 between the first dummy pattern area 301 and the second dummy pattern area 302, and a borderline B2 between the second dummy pattern area 302 and the third dummy pattern area 303 has a zigzag shape.

In this modification example, it is possible to make the boundary of the antenna pattern area 20 and each dummy pattern area 30 more obscure. Therefore, it is possible to make the antenna pattern area 20 and each dummy pattern area 30 more invisible on the surface of the display 91 and make it harder for the user of the image display device 90 to notice the antenna pattern area 20 and each dummy pattern area 30 with the naked eye.

### (Eighth Modification Example)

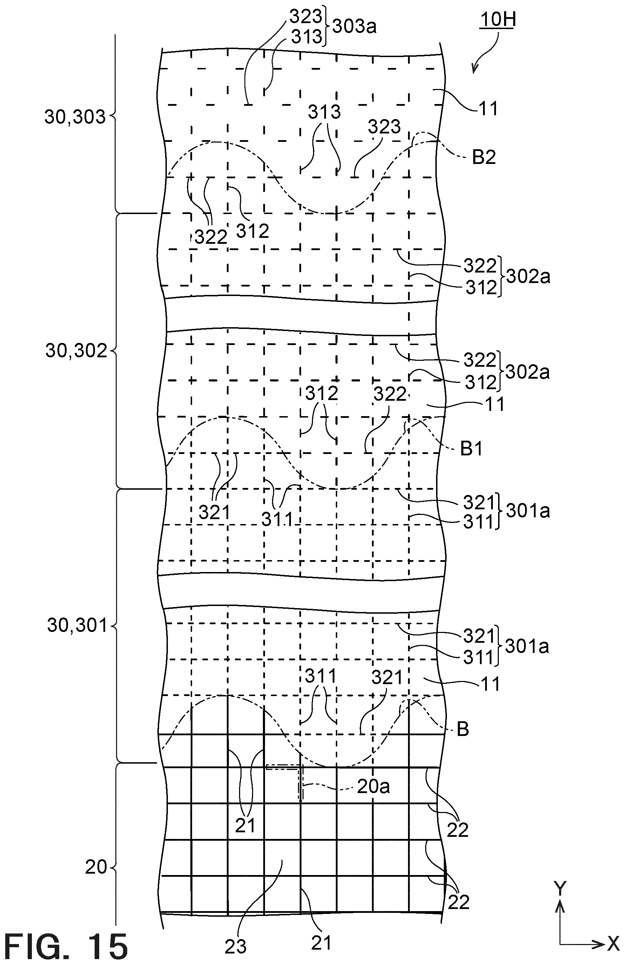

Fig. 15 illustrates a wiring board 10H according to an eighth modification example. In Fig. 15, each of a borderline B between the antenna pattern area 20 and the first dummy pattern area 301, a borderline B1 between the first dummy pattern area 301 and the second dummy pattern area 302, and a borderline B2 between the second dummy pattern area 302 and the third dummy pattern area 303 has a wavy shape.

This modification example also makes it possible to make the boundary of the antenna pattern area 20 and each dummy pattern area 30 more obscure. Therefore, it is possible to make the antenna pattern area 20 and each dummy pattern area 30 more invisible on the surface of the display 91 and make it harder for the user of the image display device 90 to notice the antenna pattern area 20 and each dummy pattern area 30 with the naked eye.

### (Ninth Modification Example)

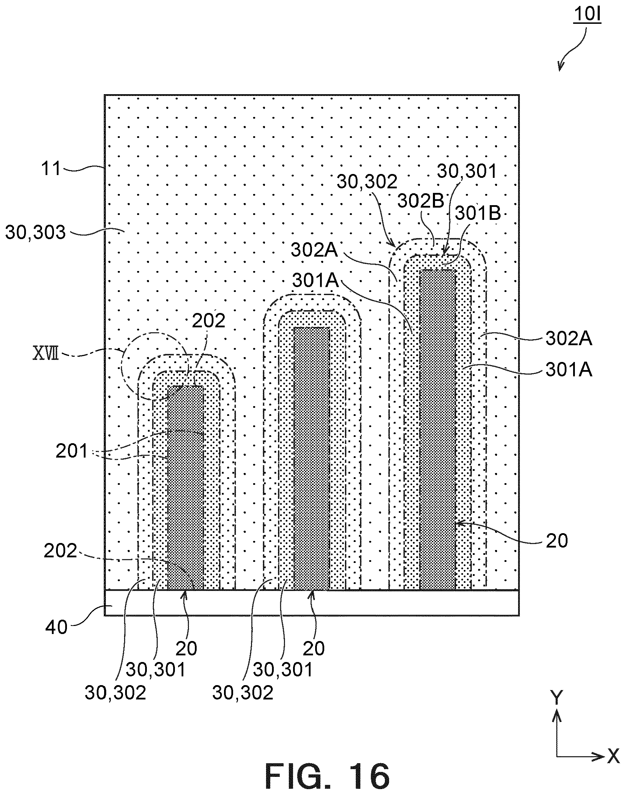

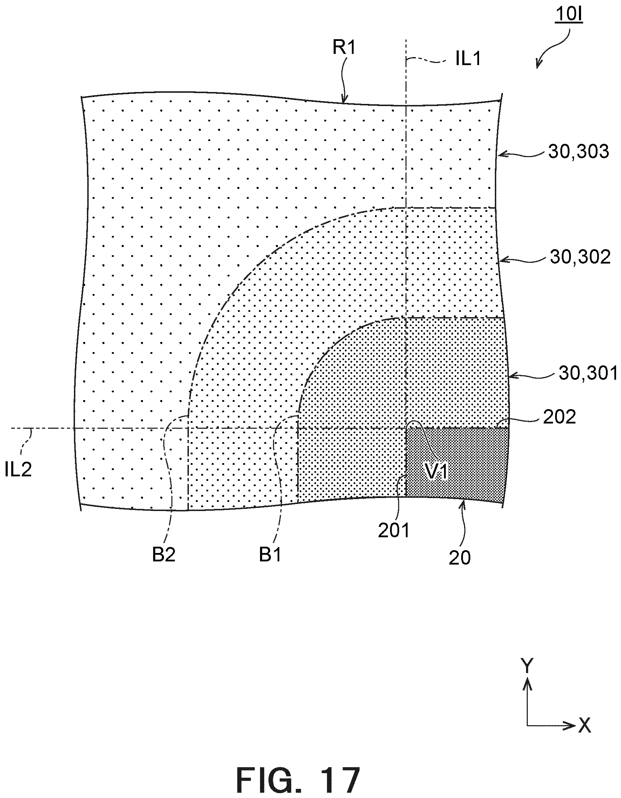

Figs. 16 and 17 illustrate a wiring board 10I according to a ninth modification example. In Figs. 16 and 17, at least a part of the outline of the first dummy pattern area 301 has an arc shape.

As described earlier, the antenna pattern area 20 has a quadrangular shape in a plan view. In this case, in a plan view, the outline of the antenna pattern area 20 has a pair of first sides 201 extending in its longer-side direction (Y direction) and a pair of second sides 202 extending in its width direction (X direction). The first side 201 and the second side 202 intersect with each other. It may be configured such that, on the first side 201 of the outline of the antenna pattern area 20, the antenna wiring 21 or the antenna interconnection wiring 22 does not overlap in parallel with the first side 201. Similarly, it may be configured such that, on the second side 202 of the outline of the antenna pattern area 20, the antenna wiring 21 or the antenna interconnection wiring 22 does not overlap in parallel with the second side 202. That is, the first side 201 and the second side 202 of the outline of the antenna pattern area 20 are sides on which the outermost portion (the side that is away from the antenna pattern area 20) of the antenna wiring 21 or the antenna interconnection wiring 22 is located.

As illustrated in Fig. 17, a vertex where the first side 201 and the second side 202 intersect with each other is defined as a first vertex V1. An extension line, of the first side 201, extending from the first vertex V1 is defined as a first virtual line IL1. An extension line, of the second side 202, extending from the first vertex V1 is defined as a second virtual line IL2. In this case, in an area R1 located between the first virtual line IL1 and the second virtual line IL2, the outline of the first dummy pattern area 301 has a shape of an arc having the center at the first vertex V1. That is, in the area R1, the borderline B1 between the first dummy pattern area 301 and the second dummy pattern area 302 has a shape of an arc having the center at the first vertex V1.

Moreover, in the area R1 located between the first virtual line IL1 and the second virtual line IL2, the outline of the second dummy pattern area 302 has a shape of an arc having the center at the first vertex V1. That is, in the area R1, the borderline B2 between the second dummy pattern area 302 and the third dummy pattern area 303 has a shape of an arc having the center at the first vertex V1. As described earlier, the number of the dummy pattern areas 30 included in the wiring board 10 (the wiring board 10I) may be any number, for example, two or more and fifty or less or so, or two or more and ten or less or so. In this case, the outline of each dummy pattern area 30 may have a shape of an arc having the center at the first vertex V1.

In a case where the antenna pattern area 20 has a quadrangular shape in a plan view, it could happen that the boundary of the antenna pattern area 20 is less invisible in the neighborhood of a corner portion (for example, the first vertex V1) of the quadrangular shape. Moreover, in this case, there is a possibility that streaks of light propagating from the corner portion of the quadrangular shape outward (toward the side that is away from the antenna pattern area 20) not in parallel with the X direction nor in parallel with the Y direction are visible due to reflection of visible light or the like. By contrast, according to this modification example, in the area R1 located between the first virtual line IL1 and the second virtual line IL2, the outline of the first dummy pattern area 301 has a shape of an arc having the center at the first vertex V1. Therefore, even in a case where the antenna pattern area 20 has a quadrangular shape in a plan view, it is possible to make it harder for the antenna pattern area 20 and streaks of light to be visually noticed effectively.

Moreover, according to this modification example, in the area R1 located between the first virtual line IL1 and the second virtual line IL2, the outline of the second dummy pattern area 302 has a shape of an arc having the center at the first vertex V1. Therefore, it is possible to make it harder for the antenna pattern area 20 and streaks of light to be visually noticed effectively.

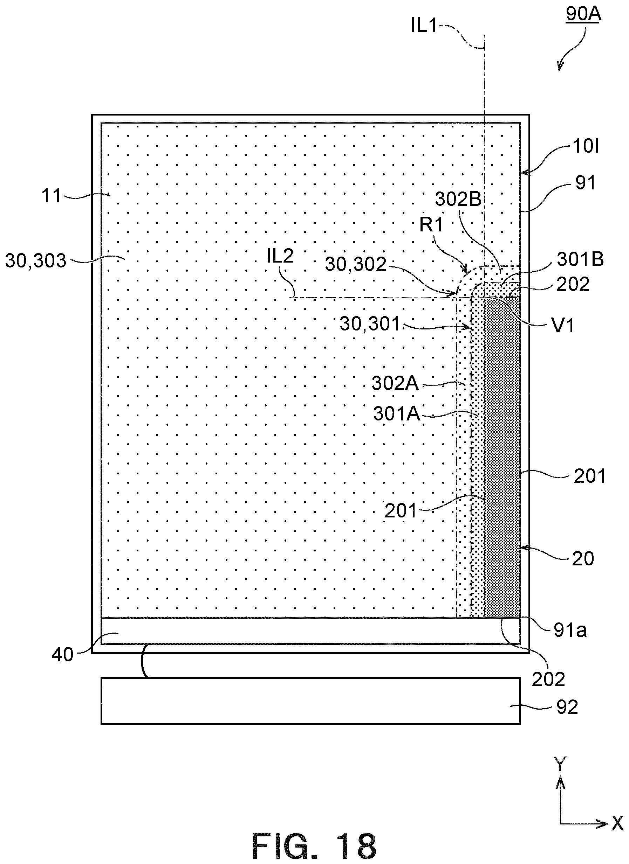

In this modification example, as illustrated in Fig. 18, in the image display device, the antenna pattern area 20 may be provided at a corner portion 91a of the display 91. Fig. 18 illustrates an image display device 90A according to a modification example. In this modification example, each dummy pattern area 30 is provided in such a way as to surround all of the periphery sides (the negative side in the X direction and the positive side in the Y direction) of the antenna pattern area 20, except for the positive side in the X direction and the negative side in the Y direction (the side facing the power feeding portion 40). In this case, it is possible to make it harder for the above-described streaks of light to be visually noticed more effectively.

### (Tenth Modification Example)

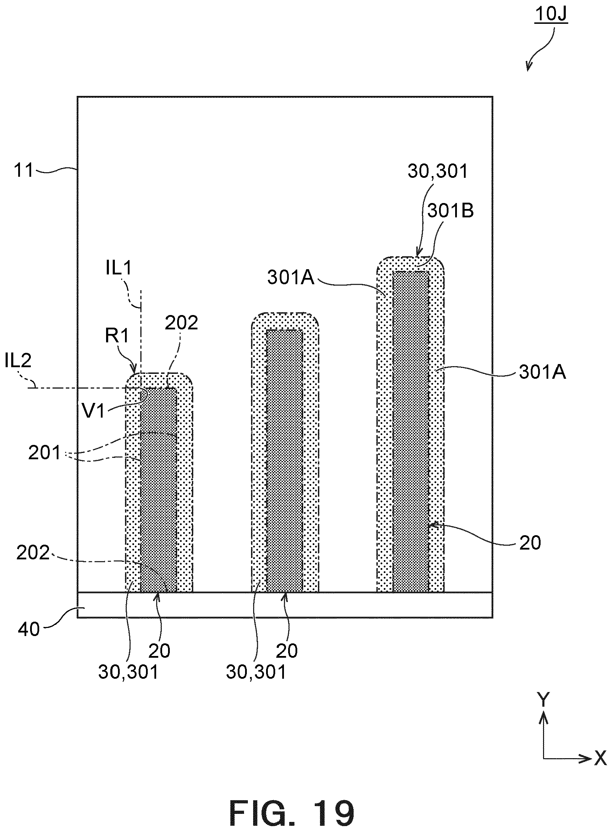

Fig. 19 illustrates a wiring board 10J according to a tenth modification example. In Fig. 19, the wiring board 10J includes a single dummy pattern area 30. That is, the wiring board 10J includes only the first dummy pattern area 301 located next to the antenna pattern area 20.

Also in this modification example, in the area R1 located between the first virtual line IL1 and the second virtual line IL2, the outline of the first dummy pattern area 301 has a shape of an arc having the center at the first vertex V1; therefore, even in a case where the antenna pattern area 20 has a quadrangular shape in a plan view, it is possible to make it harder for the antenna pattern area 20 and streaks of light to be visually noticed effectively.

### (Eleventh Modification Example)

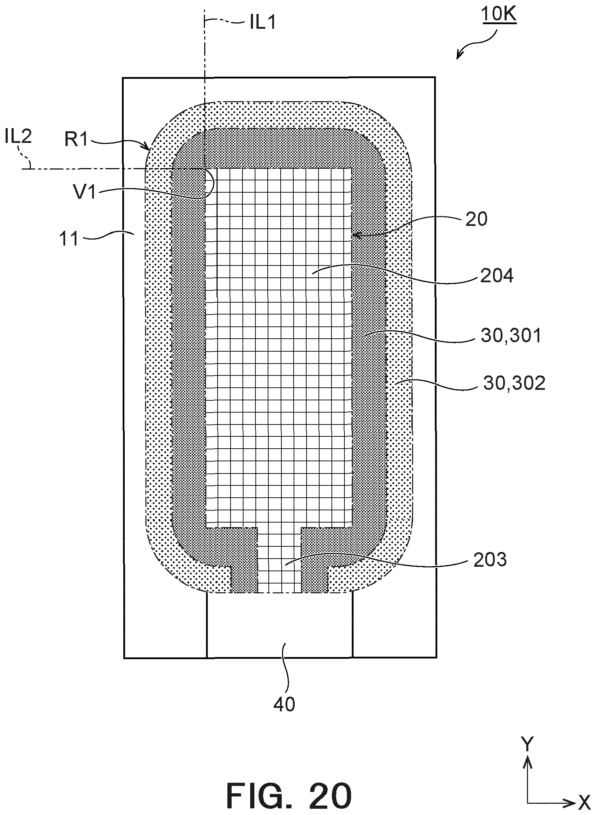

Fig. 20 illustrates a wiring board 10K according to an eleventh modification example. In Fig. 20, the antenna pattern area 20 has a base-end-side portion 203, which is located closer to the power feeding portion 40, and a head-end-side portion 204, which is connected to the base-end-side portion 203. Each of the base-end-side portion 203 and the head-end-side portion 204 has a quadrangular shape in a plan view. In this case, the length (Y-directional distance) of the head-end-side portion 204 is greater than the length (Y-directional distance) of the base-end-side portion 203, and the width (X-directional distance) of the head-end-side portion 204 is greater than the width (X-directional distance) of the base-end-side portion 203. Also in this case, it is possible to make it harder for the antenna pattern area 20 to be visually noticed effectively. In the illustrated example, the wiring board 10K includes two dummy pattern areas 30 (301 and 302), but is not limited thereto. The wiring board 10K may include three or more dummy pattern areas 30. In this case, the outline of each dummy pattern area 30 may have a shape of an arc having the center at the first vertex V1.

### (Twelfth Modification Example)

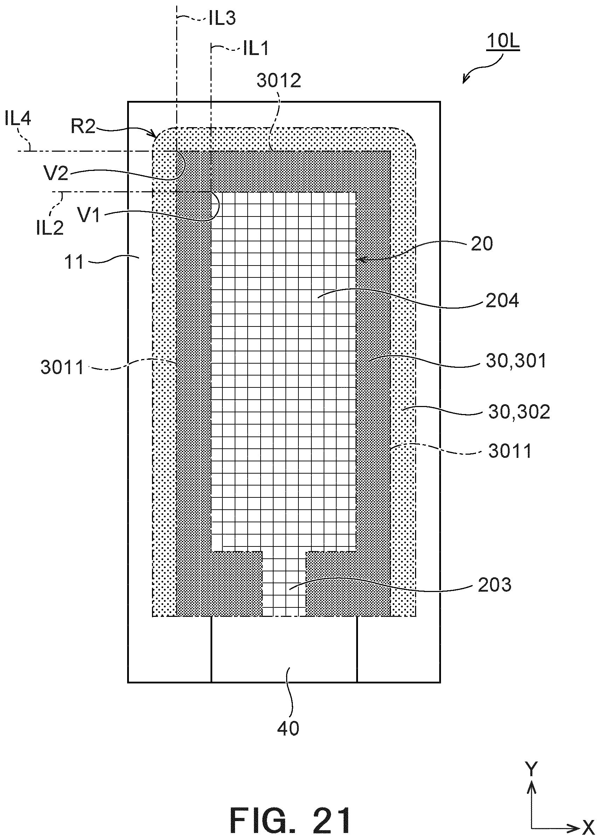

Fig. 21 illustrates a wiring board 10L according to a twelfth modification example. In Fig. 21, the outline of the first dummy pattern area 301 does not have a shape of an arc having the center at the first vertex V1.

In this case, in a plan view, the outline of the first dummy pattern area 301 has a pair of third sides 3011 extending in its longer-side direction (Y direction) and a fourth side 3012 extending in its width direction (X direction). The third side 3011 and the fourth side 3012 intersect with each other. It may be configured such that, on the third side 3011 of the outline of the first dummy pattern area 301, the first dummy wiring portion 311 or the second dummy wiring portion 321 does not overlap in parallel with the third side 3011. Similarly, it may be configured such that, on the fourth side 3012 of the outline of the first dummy pattern area 301, the first dummy wiring portion 311 or the second dummy wiring portion 321 does not overlap in parallel with the fourth side 3012. That is, the third side 3011 and the fourth side 3012 of the outline of the first dummy pattern area 301 are sides on which the outermost portion (the side that is away from the antenna pattern area 20) of the first dummy wiring portion 311 or the second dummy wiring portion 321 is located.

As illustrated in Fig. 21, a vertex where the third side 3011 and the fourth side 3012 intersect with each other is defined as a second vertex V2. An extension line, of the third side 3011, extending from the second vertex V2 is defined as a third virtual line IL3. An extension line, of the fourth side 3012, extending from the second vertex V2 is defined as a fourth virtual line IL4. In this case, in an area R2 located between the third virtual line IL3 and the fourth virtual line IL4, the outline of the second dummy pattern area 302 has a shape of an arc having the center at the second vertex V2. As described earlier, the number of the dummy pattern areas 30 included in the wiring board 10 (the wiring board 10L) may be any number, for example, two or more and fifty or less or so, or two or more and ten or less or so. In this case, the outline of each dummy pattern area 30, except for the first dummy pattern area 301, may have a shape of an arc having the center at the second vertex V2.

As described earlier, the aperture ratio A21 of the first dummy pattern area 301 is not lower than the aperture ratio A1 of the antenna pattern area 20. In a case where the aperture ratio A21 is equal to the aperture ratio A1, it is possible to prevent the boundary of the antenna pattern area 20 from being less invisible in the neighborhood of a corner portion (for example, the first vertex V1) of the antenna pattern area 20, or reduce the risk thereof. Therefore, even in a case where the outline of the first dummy pattern area 301 does not have a shape of an arc having the center at the first vertex V1 in the area R1 located between the first virtual line IL1 and the second virtual line IL2, it is possible to make it harder for the antenna pattern area 20 and streaks of light to be visually noticed.

On the other hand, in this case, the aperture ratio A21 of the first dummy pattern area 301 may be lower than the aperture ratio A22 of the second dummy pattern area 302. That is, the aperture ratio A22 of the second dummy pattern area 302 may be higher than the aperture ratio A21 of the first dummy pattern area 301 for the purpose of increasing the aperture ratio A3 of the wiring board 10L as a whole.

In a case where the outline of the first dummy pattern area 301 includes the third side 3011 and the fourth side 3012 intersecting with each other in a plan view, it could happen that the boundary of the first dummy pattern area 301 is less invisible in the neighborhood of the second vertex V2 where the third side 3011 and the fourth side 3012 intersect with each other. Moreover, in this case, there is a possibility that streaks of light propagating from the second vertex V2 outward not in parallel with the X direction nor in parallel with the Y direction are visible due to reflection of visible light or the like. By contrast, according to this modification example, in the area R2 located between the third virtual line IL3 and the fourth virtual line IL4, the outline of the second dummy pattern area 302 has a shape of an arc having the center at the second vertex V2. Therefore, it is possible to make it harder for the first dummy pattern area 301 and streaks of light to be visually noticed effectively.

### (Thirteenth Modification Example)

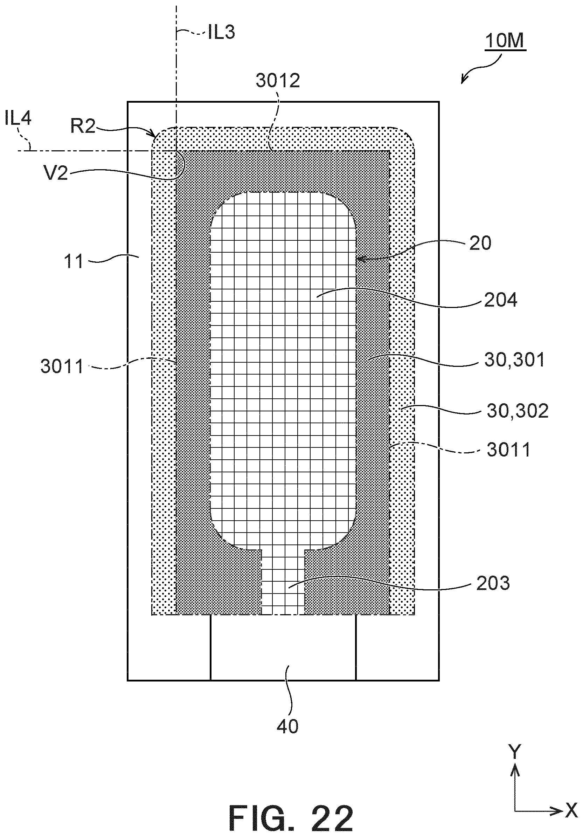

Fig. 22 illustrates a wiring board 10M according to a thirteenth modification example. In Fig. 22, the antenna pattern area 20 has a quadrangular shape with rounded corners in a plan view. Therefore, the antenna pattern area 20 does not have a shape that includes a corner portion that might make the boundary of the antenna pattern area 20 less invisible. Therefore, even in a case where the outline of the first dummy pattern area 301 does not have a shape of an arc having the center at the first vertex V1 in the area R1 (see Fig. 21, etc.) described above, it is possible to make it harder for the antenna pattern area 20 and streaks of light to be visually noticed.

Moreover, also in this modification example, in the area R2 located between the third virtual line IL3 and the fourth virtual line IL4, the outline of the second dummy pattern area 302 may have a shape of an arc having the center at the second vertex V2. This makes it harder for the first dummy pattern area 301 and streaks of light to be visually noticed effectively.

### (Fourteenth Modification Example)

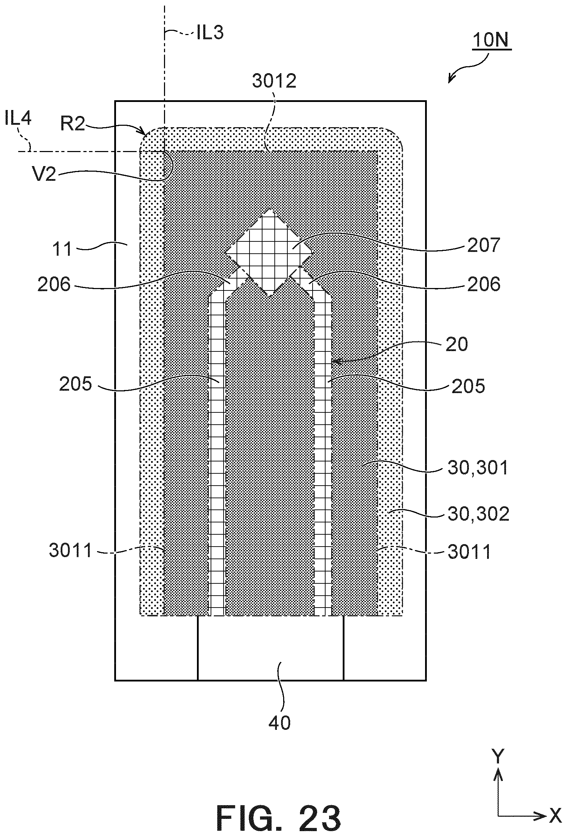

Fig. 23 illustrates a wiring board 10N according to a fourteenth modification example. In Fig. 23, the antenna pattern area 20 includes a pair of first electric transfer portions 205 connected to the power feeding portion 40, a pair of second electric transfer portions 206 connected to the pair of first electric transfer portions 205 respectively, and a transceiver portion 207 connected to the pair of second electric transfer portions 206. Each of the pair of first electric transfer portions 205 extends in the longer-side direction (Y direction) of the antenna pattern area 20. Each of the pair of second electric transfer portions 206 extends obliquely with respect to the Y direction such that they come closer to each other as viewed toward the positive side in the Y direction. The transceiver portion 207 has a quadrangular shape including a diagonal line extending in the X direction and a diagonal line extending in the Y direction in a plan view.

Also in this modification example, in a case where the aperture ratio A21 of the first dummy pattern area 301 is equal to the aperture ratio A1, it is possible to make it harder for the antenna pattern area 20 and streaks of light to be visually noticed.

Moreover, also in this modification example, in the area R2 located between the third virtual line IL3 and the fourth virtual line IL4, the outline of the second dummy pattern area 302 may have a shape of an arc having the center at the second vertex V2. This makes it harder for the first dummy pattern area 301 and streaks of light to be visually noticed effectively.

### (Fifteenth Modification Example)

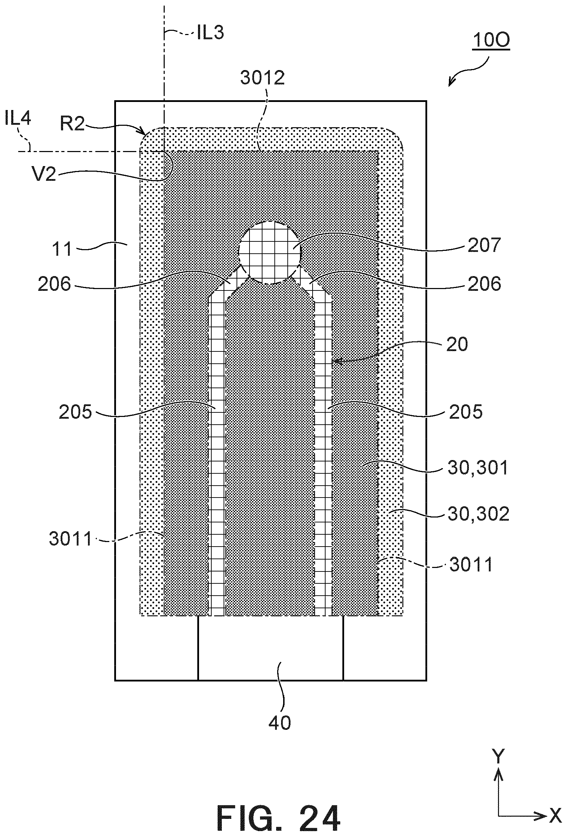

Fig. 24 illustrates a wiring board 100 according to a fifteenth modification example. In Fig. 24, the transceiver portion 207 has a circular shape in a plan view.

Also in this modification example, in a case where the aperture ratio A21 of the first dummy pattern area 301 is equal to the aperture ratio A1, it is possible to make it harder for the antenna pattern area 20 and streaks of light to be visually noticed.

Moreover, also in this modification example, in the area R2 located between the third virtual line IL3 and the fourth virtual line IL4, the outline of the second dummy pattern area 302 may have a shape of an arc having the center at the second vertex V2. This makes it harder for the first dummy pattern area 301 and streaks of light to be visually noticed effectively.

Plural elements disclosed in the foregoing embodiment and the modification examples can be combined as appropriate, where necessary. Alternatively, some elements may be deleted from among all of the elements disclosed in the foregoing embodiment and the modification examples.

## Claims

1. A wiring board, comprising:
a substrate;
a wiring pattern area arranged on the substrate and including pieces of wiring; and
a plurality of dummy pattern areas arranged around the wiring pattern area and electrically independent of the wiring, wherein
the substrate has transparency,
among the plurality of dummy pattern areas, an aperture ratio of a first dummy pattern area, which is located next to the wiring pattern area, is not lower than an aperture ratio of the wiring pattern area, and
among the plurality of dummy pattern areas, an aperture ratio of a second dummy pattern area, which is located next to the first dummy pattern area and farther from the wiring pattern area than the first dummy pattern area is, is higher than the aperture ratio of the first dummy pattern area.

2. The wiring board according to claim 1, wherein
each as the wiring pattern area, a plurality of wiring pattern areas exists, and
at least one of the plurality of dummy pattern areas is provided in such a way as to surround the plurality of wiring pattern areas.

3. The wiring board according to claim 1 or 2, wherein
the aperture ratio of the wiring pattern area and aperture ratios of the plurality of dummy pattern areas increase stepwise from the wiring pattern area toward the dummy pattern areas located farther from the wiring pattern area,
a difference between the aperture ratio of the first dummy pattern area and the aperture ratio of the wiring pattern area is within a range from 0% inclusive to 2% inclusive, and
a difference between the aperture ratios of the dummy pattern areas located next to each other is within a range from 0.02% inclusive to 2% inclusive.

4. The wiring board according to any of claims 1 to 3, further comprising:
a peripheral area located around the dummy pattern area that is farthest from the wiring pattern area, wherein
the peripheral area has an aperture ratio of 100%.

5. The wiring board according to claim 4, wherein
the aperture ratio of the wiring pattern area and aperture ratios of the plurality of dummy pattern areas increase stepwise from the wiring pattern area toward the dummy pattern areas located farther from the wiring pattern area,
a difference between the aperture ratio of the first dummy pattern area and the aperture ratio of the wiring pattern area is within a range from 0% inclusive to 2% inclusive, and
each of a difference between the aperture ratios of the dummy pattern areas located next to each other and a difference between the aperture ratio of the peripheral area and the dummy pattern area located next to the peripheral area is within a range from 0.02% inclusive to 2% inclusive.

6. The wiring board according to any of claims 1 to 5, wherein
an outline of the wiring pattern area includes a first side and a second side that intersect with each other in a plan view,
a vertex where the first side and the second side intersect with each other is defined as a first vertex,
an extension line, of the first side, extending from the first vertex is defined as a first virtual line,
an extension line, of the second side, extending from the first vertex is defined as a second virtual line, and
given above definition, in an area located between the first virtual line and the second virtual line, an outline of the first dummy pattern area has a shape of an arc having a center at the first vertex.

7. The wiring board according to claim 6, wherein
in the area located between the first virtual line and the second virtual line, an outline of the second dummy pattern area has a shape of an arc having a center at the first vertex.

8. A wiring board, comprising:
a substrate;
a wiring pattern area arranged on the substrate and including pieces of wiring; and
a plurality of dummy pattern areas arranged around the wiring pattern area and electrically independent of the wiring, wherein
the substrate has transparency,
an aperture ratio of a first dummy pattern area, which is located next to the wiring pattern area, among the plurality of dummy pattern areas is lower than an aperture ratio of a second dummy pattern area, which is located next to the first dummy pattern area and farther from the wiring pattern area than the first dummy pattern area is, among the plurality of dummy pattern areas,
an outline of the first dummy pattern area includes a third side and a fourth side that intersect with each other in a plan view,
a vertex where the third side and the fourth side intersect with each other is defined as a second vertex,
an extension line, of the third side, extending from the second vertex is defined as a third virtual line,
an extension line, of the fourth side, extending from the second vertex is defined as a fourth virtual line, and
given above definition, in an area located between the third virtual line and the fourth virtual line, an outline of the second dummy pattern area has a shape of an arc having a center at the second vertex.

9. The wiring board according to any of claims 1 to 8, wherein
each of the plurality of dummy pattern areas includes pieces of dummy wiring that are electrically independent of the wiring,
each of the pieces of dummy wiring includes a first dummy wiring portion and a second dummy wiring portion,
the first dummy wiring portions of the dummy pattern areas located next to each other are arranged in parallel with each other, and
the second dummy wiring portions of the dummy pattern areas located next to each other are arranged in parallel with each other.

10. The wiring board according to any of claims 1 to 9, wherein
the wiring pattern area further includes pieces of interconnection wiring interconnecting the pieces of wiring,
each of the plurality of dummy pattern areas includes pieces of dummy wiring that are electrically independent of the wiring and the interconnection wiring,
each of the pieces of dummy wiring includes a first dummy wiring portion and a second dummy wiring portion,
the wiring and the first dummy wiring portion of each of the dummy pattern areas are arranged in parallel with each other, and
the interconnection wiring and the second dummy wiring portion of each of the dummy pattern areas are arranged in parallel with each other.

11. A wiring board, comprising:
a substrate;
a wiring pattern area arranged on the substrate and including pieces of wiring; and
a dummy pattern area arranged around the wiring pattern area and electrically independent of the wiring, wherein
the substrate has transparency,
an outline of the wiring pattern area includes a first side and a second side that intersect with each other in a plan view,
a vertex where the first side and the second side intersect with each other is defined as a first vertex,
an extension line, of the first side, extending from the first vertex is defined as a first virtual line,
an extension line, of the second side, extending from the first vertex is defined as a second virtual line, and
given above definition, in an area located between the first virtual line and the second virtual line, an outline of the first dummy pattern area has a shape of an arc having a center at the first vertex.

12. The wiring board according to any of claims 1 to 11 having a radio-wave transmitting-and-receiving function.

13. An image display device, comprising:
the wiring board according to any of claims 1 to 12, and
a display device underlying the wiring board, wherein
the wiring pattern area is provided at a corner portion of the display device.

14. A method of manufacturing a wiring board, comprising:
preparing a substrate; and
forming, on the substrate, a wiring pattern area including pieces of wiring, and a plurality of dummy pattern areas arranged around the wiring pattern area and electrically independent of the wiring, wherein
the substrate has transparency,
among the plurality of dummy pattern areas, an aperture ratio of a first dummy pattern area, which is located next to the wiring pattern area, is not lower than an aperture ratio of the wiring pattern area, and
among the plurality of dummy pattern areas, an aperture ratio of a second dummy pattern area, which is located next to the first dummy pattern area and farther from the wiring pattern area than the first dummy pattern area is, is higher than the aperture ratio of the first dummy pattern area.

15. A method of manufacturing a wiring board, comprising:
preparing a substrate; and
forming, on the substrate, a wiring pattern area including pieces of wiring, and a dummy pattern area arranged around the wiring pattern area and electrically independent of the wiring, wherein
the substrate has transparency,
an outline of the wiring pattern area includes a first side and a second side that intersect with each other in a plan view,
a vertex where the first side and the second side intersect with each other is defined as a first vertex,
an extension line, of the first side, extending from the first vertex is defined as a first virtual line,
an extension line, of the second side, extending from the first vertex is defined as a second virtual line, and
given above definition, in an area located between the first virtual line and the second virtual line, an outline of the first dummy pattern area has a shape of an arc having a center at the first vertex.

16. A method of manufacturing a wiring board, comprising:
preparing a substrate; and
forming, on the substrate, a wiring pattern area including pieces of wiring, and a plurality of dummy pattern areas arranged around the wiring pattern area and electrically independent of the wiring, wherein
the substrate has transparency,
an aperture ratio of a first dummy pattern area, which is located next to the wiring pattern area, among the plurality of dummy pattern areas is lower than an aperture ratio of a second dummy pattern area, which is located next to the first dummy pattern area and farther from the wiring pattern area than the first dummy pattern area is, among the plurality of dummy pattern areas,
an outline of the first dummy pattern area includes a third side and a fourth side that intersect with each other in a plan view,
a vertex where the third side and the fourth side intersect with each other is defined as a second vertex,
an extension line, of the third side, extending from the second vertex is defined as a third virtual line,
an extension line, of the fourth side, extending from the second vertex is defined as a fourth virtual line, and
given above definition, in an area located between the third virtual line and the fourth virtual line, an outline of the second dummy pattern area has a shape of an arc having a center at the second vertex.
